(19) **Europäisches Patentamt**
**European Patent Office**
**Office européen des brevets**

(11) **EP 1 516 336 B1**

(12) **EUROPEAN PATENT SPECIFICATION**

(45) Date of publication and mention
of the grant of the patent:
**01.09.2010 Bulletin 2010/35**

(51) Int Cl.:
***G11B 20/12*** *(2006.01)*        ***G11B 27/30*** *(2006.01)*

(21) Application number: **03732870.5**

(22) Date of filing: **13.06.2003**

(86) International application number:
**PCT/IB2003/002542**

(87) International publication number:
**WO 2004/003909 (08.01.2004 Gazette 2004/02)**

(54) **DATA OVERWRITING IN PROBE-BASED DATA STORAGE DEVICES**

ÜBERSCHREIBEN VON DATEN IN DATENSPEICHERVORRICHTUNGEN BASIEREND AUF EINER MESSSONDE

ECRASEMENT DE DONNEES DANS DES DISPOSITIFS DE STOCKAGE DE DONNEES BASES SUR DES SONDES

(84) Designated Contracting States:
**AT BE BG CH CY CZ DE DK EE ES FI FR GB GR HU IE IT LI LU MC NL PT RO SE SI SK TR**

(30) Priority: **27.06.2002 EP 02405541**

(43) Date of publication of application:
**23.03.2005 Bulletin 2005/12**

(73) Proprietor: **International Business Machines Corporation**
**Armonk, NY 10504 (US)**

(72) Inventors:
• **ANTONAKOPOULOS, Theodore**
**GR-26224 Patras (GR)**
• **ELEFTHERIOU, Evangelos, S.**
**CH-8038 Zurich (CH)**
• **POZIDIS, Haris**
**CH-8136 Gattikon (CH)**

(74) Representative: **Toleti, Martin**
**IBM Research GmbH**
**Zurich Research Laboratory**
**Säumerstrasse 4**
**Postfach**
**8803 Rüschlikon (CH)**

(56) References cited:
**EP-A- 0 718 831      EP-A- 0 991 060**
**EP-A- 1 056 077**

• **VETTIGER, CROSS, DESPONT, DRECHSLER, ETC.: "Millipede-Nanotechnology Entering Data Storage" IEEE TRANSACTION OF NANOTECHNOLOGY, [Online] vol. 1, no. 1, March 2002 (2002-03), pages 39-55, XP002255614 Retrieved from the Internet: <URL:www-mtl.mit.edu> [retrieved on 2003-09-24]**

**Description**

This invention relates generally to probe-based data storage devices, and more particularly to overwriting of data in such devices. Embodiments of the invention provide methods and apparatus enabling data to be stored in such devices without first erasing previously-written data.

Probe-based data storage has long been recognized as a possible basis for ultrahigh density data storage. In probe-based data storage devices, stored data is represented on a storage surface by the presence and absence of indentations, or "pits", which are formed in the surface by a probe of the device. For example, in AFM (Atomic Force Microscope)-based storage devices, the probe is a nanometer-sharp tip mounted on the end of a microfabricated cantilever. This tip can be moved over the surface of a storage medium in the form of a polymer substrate. A mechanism is provided for heating the tip, and thus the polymer surface at the point of contact with the tip, allowing the tip to penetrate the surface to create a pit. Such a pit typically represents a bit of value "1", a bit of value "0" being represented by the absence of a pit at a bit position on the storage surface. In a read-scan mode, the thermomechanical probe mechanism can be used to read-back data by detecting the deflection of the cantilever as the tip is moved over the pattern of bit indentations. AFM-based data storage is described in detail in ISM Journal of Research & Development, Volume 44, No. 3, May 2000, pp323-340, "The 'Millipede'- More Than One Thousand Tips for Future AFM Data Storage", Vettiger et al., and the references cited therein. As described in this document, while basic read/write operations can be implemented using a single cantilever probe, in practice an integrated array of individually-addressable cantilevers is employed in order to increase data rates.

A basic write operation in these probe-based storage devices thus involves creation of a pit in the storage surface by a micromechanical probe mechanism. As the pit is created, material is displaced by the probe and deposited in the area around the indentation. In the AFM-based device discussed above for example, melted polymer is deposited in the area around a pit creating "donut walls", or "rings", which have a higher topological profile than the polymer background. If a pit is formed sufficiently near to an existing pit, the displaced material can partly fill the existing pit, effectively changing a "1" to a "0" and thus erasing the "1". The physical mechanism exploited for probe-based data storage thus imposes a limit on the smallest distance between pits created during a data write operation. This minimum distance $T_{min}$ is the smallest distance between adjacent pits created during a write operation for which writing the second pit will not erase the first pit due to displacement of material. For basic data write operations this limit $T_{min}$ translates into a minimum allowable distance between stored data bits.

When overwriting of old data with new data is contemplated in probe-based storage devices, certain difficulties arise as a consequence of the mechanism employed for data storage. For example, since a zero corresponds to "no pit" at a bit position, writing a zero at a bit position corresponds to no action. Hence, "writing" a zero over a previously-written "1" at a bit position will leave the "1" in tact, rendering the newly-written data incorrect. Because of such problems, prior to our copending European Patent Application No. 02010648.0 filed 13 May 2002, probe-based data storage relied on the writing of data on "clean" storage surfaces, i.e. surfaces on which data has not previously been written or from which old data has been erased. For example, in the case of the Millipede device discussed earlier, old data can be erased by heating the storage surface to cause melting and "reflow" of the polymer. However, erasing of old data is clearly a power and time intensive process. In our European patent application referenced above, a system is disclosed which allows direct overwriting of old data with new data in probe-based data storage devices. This system effectively involves a two-stage coding process. In the first stage, input data is coded to prevent occurrence of two consecutive bits of a given value "x" in the coded input data. If x = 1 for example, then the coding ensures that successive "1's" in the coded input data are separated by at least "d" zeros, where d is a predetermined number $\geq 1$. The effect of this coding is to ensure that successive pits to be left in the storage surface after a write operation are always separated by at least one "no-pit". This coding therefore allows the stored bit density to be increased over the uncoded case where the minimum bit spacing is constrained to $T_{min}$ as explained above. In the second coding stage, an algorithm is employed to generate an overwrite bit sequence from the coded input bit sequence. In simple terms, the algorithms employed here are based on the premise that writing a pit can erase an existing, neighboring pit on either side of the new pit due to displacement of material as discussed above. When the resulting overwrite bit sequence is written on the storage surface, the effect is to record either the original coded input bit sequence, or the complement of this bit sequence, depending on particular operating parameters. This result is independent of the bit values of the old data which is overwritten, and hence erasing of old data is not required.

The power expenditure in any data write operation in probe-based storage devices is directly related to the number of pits formed in the storage surface. From the principles underlying the overwrite system outlined above, it follows that writing an overwrite sequence generated from a given coded input bit sequence necessarily involves writing more pits than would writing the coded input bit sequence directly (though the latter operation would not of course allow overwriting of old data). The overwrite operation thus requires more power for given input data than a conventional write operation on a clean storage surface. Power consumption, always an important consideration, is thus a more prominent factor where direct-overwrite capability is provided. The present invention enables direct overwriting to be achieved with reduced power consumption compared to methods disclosed in our European patent application referenced above.

Other prior art references refer to optical phase change recording applications:

EP 0 718 831 A2 discloses a recording and reproducing method and apparatus for an optical disk of the phase transition type that can be overwritten. The capacity of repeated rewriting of the optical disk is expanded by recording either non-inverted write data or inverted write data at random. The deterioration due to the repeated rewriting at a start point and an end point of the recording is suppressed by recording a synchronizing signal before the write data and/or dummy data after the write data in the way such that thermal stress is less likely to occur. A record end position can be determined precisely by detecting a stop pulse to stop recording. EP 0 991 060 A2 discloses an optical information recording apparatus, an optical information recording method, and an optical information recording medium that enable information signals to be recorded precisely by determining recording conditions such as recording power, edge positions of recording pulses, and the like suitably before recording information signals. An edge test signal generation circuit supplies a test signal for optimizing edge positions of recording pulses. In order to suppress the variation in intervals between edges due to mark distortion caused by overwriting, test recording is carried out using this test signal in a plurality of sectors on the optical information recording medium with a test recording start point being shifted at random in each sector by a recording start point shifting circuit. A system control circuit calculates an average of intervals between edges in test signals reproduced from the plurality of sectors and determines the difference between the average and an original interval between edges in the test signal, thus determining a compensation volume for edge positions.

EP 1 056 077 A2 refers to a rewritable compact disc having a wobble groove on a substrate and phase-change recording layer comprising one selected from the compositions represented by MzGey(SbxTe1-x)1-y-z (where $0 \leq z \leq 0.1$, $0 < y \leq 0.1$, $0.72 \leq x \leq 0.8$, and M is at least one element selected from the group consisting of In, Ga, Si, Sn, Pb, Pd, Pt, Zn, Au, Ag, Zr, Hf, V, Nb, Ta, Cr, Co, Bi, O, N, S and rare earth metal elements) or by A1aA2bGec(SbdTe1-d)1-a-b-c (where $0 < a \leq 0.1$, $0 < b \leq 0.1$, $c < b < a$, $0.02 < c \leq 0.2$, $0.72 \leq d \leq 0.8$, and A1 is at least one element selected from the group consisting of Zn, Pd, Pt, V, Nb, Ta, Cr, Co, Si, Sn, Pb, Bi, O, N, S and rare earth metal elements, and A2 is at least one element selected from the group consisting of Ga and In). Recording at 8-times or higher velocities is realized by a divided pulse method without any risk of impairing the read-compatibility with the conventional CD-RW specifications at least at 4-times velocity.

According to one aspect of the present invention there is provided a method for overwriting data in a probe-based data storage device wherein data is represented by the presence and absence of pits formed in a storage surface by a probe of the device. The method comprises:

coding input data such that successive bits of a value x in the coded input data are separated by at least d bits of value $\bar{x}$, where d is a predetermined number $\geq 2$;

generating overwrite data bits by encoding the coded input data bits such that, if a pit represents a bit of value p in the data storage device, then

(a) any bit of value x in the coded input data is encoded as an overwrite data bit of value p,

(b) any bounded run of $L \leq 2d$ bits of value $\bar{x}$ in the coded input data is encoded as a run of L overwrite data bits of value $\bar{p}$, and

(c) any bounded run of $L > 2d$ bits of value $\bar{x}$ in the coded input data is encoded as a run of L overwrite data bits consisting of n bits of value p and (L - n) bits of value $\bar{p}$ where n = CEIL[(L - 2d)/d] and the n bits are positioned in the run such that

(c1) there is a bit of value p within d bits of the end of the run,

(c2) there is a bit of value p within 2d + 1 bits of the beginning of the run, and

(c3) for n > 1, each of the n bits is within d bits of another of the n bits; and

overwriting data on the storage surface with the overwrite data bits at a bit spacing such that writing an overwrite data bit of value p can erase an existing bit of value p within d bits of that overwrite data bit.

Thus, in overwrite methods embodying the invention, the input data to be stored in the device is first coded to ensure that, in the coded input data, successive bits of a particular value x (which may be 0 or 1 in different embodiments) are separated by at least d bits of the complementary value $\bar{x}$ (where the symbol here and throughout signifies bit inversion). The predetermined number d in this coding process is $\geq 2$. An overwrite bit sequence is then generated from the coded input bit sequence by an encoding process which satisfies the three conditions (a), (b) and (c). Condition (a) requires that any bit of value x in the coded input data is encoded as an overwrite data bit of value p, where p is the bit value which is represented by a pit in the data storage device. That is, p is the bit value which is written as a pit in the data storage device, the bit value p thus corresponding to "no-pit", where p can of course be 0 or 1 in different embodiments. Condition (b) specifies the encoding for bounded runs of length $L \leq 2d$ bits, all of value $\bar{x}$, in the coded input data, where a "bounded run" as used herein is a run of bits of a given value which is bounded on both sides by a bit of the complementary value. For instance, a bounded run of L zeros is immediately preceded by a "1" and immediately followed by a "1". According to condition (b), any bounded run consisting of L bits of value $\bar{x}$ in the coded input data, where L ≤ 2d, is encoded as a run of L overwrite data bits of value $\bar{p}$. Condition (c) specifies the encoding for bounded runs of length L > 2d bits, all of value $\bar{x}$, in the coded input data. Each such L-bit run is encoded as a run of L overwrite data bits which consists of n bits of value p and (L - n) bits of value $\bar{p}$, where n = CEIL[(L - 2d)/d]. (The known function CEIL(y) represents the smallest integer that is greater than or equal to y). The n bits of value p are positioned in the L-bit run here such that all of the three sub-conditions (c1), (c2) and (c3) specified above are satisfied. The overwrite bit sequence generated according to this encoding process can then be written on the storage surface over existing, previously-written data. The bit spacing for this overwrite operation is set such that writing an overwrite bit of value p (i.e. writing a pit on the storage surface) can erase an existing bit of value p within d bits of that overwrite bit. This bit-spacing condition will be explained in more detail below.

The result of writing the overwrite bit sequence on the storage surface depends on the relationship between the values p and x. If p = x, then the bit sequence recorded on the storage surface will be the original coded input data. In the alternative case where p = $\bar{x}$, the recorded bit sequence will be the complement (i.e. the bit-inversion) of the coded input data. This will be demonstrated below, and in both cases it will be seen that the result is independent of the bit values of the old data which is overwritten. The need to erase old data is therefore avoided. Moreover, direct overwriting is accomplished with substantially reduced power as compared with methods disclosed in our earlier patent application referenced above. Indeed, particular methods embodying the invention provide for optimal overwrite operations wherein direct overwriting is achieved with minimum power consumption. These power advantages will be explained in more detail below.

The present invention is predicated on the realization that for d ≥ 2, when advantage is taken of the higher surface bit densities permitted by this d-constraint, direct overwriting can be achieved by writing fewer pits in the storage surface than are required by the methods in our earlier patent application referenced above. In particular, a d ≥ 2 constraint permits a bit spacing for writing of the overwrite sequence such that writing a pit can erase an existing pit within ±d bit positions. Methods embodying the invention generate overwrite bit sequences which exploit this effect, enabling direct overwriting to be achieved by writing fewer pits in the storage surface.

For coded input data sequences which begin and end with a bit of value x, conditions (a) to (c) above are sufficient for encoding the entire coded input data sequence. In such cases, the resulting overwrite data sequence will be optimal in the sense that the overwrite sequence contains the minimum possible number of bits of value p required for the overwrite operation. Since bits of value p are written as pits on the storage surface, this translates to a minimum number of pits and hence minimum power consumption for the overwrite operation. In general, of course, a coded bit sequence might start and/or end with a run of bits of value x. These runs could be encoded in various ways in the overwrite sequence, with relatively minor impact on overall power consumption since the remainder of the bit sequence will be optimally encoded as just described. However, in preferred embodiments such start and/or end runs can be optimally encoded in the following manner. Considering first a run of L bits of value $\bar{x}$ at the start of the coded input data for an overwrite operation, this can be optimally encoded by:

if L ≤ d, encoding the run as a run of L overwrite data bits of value $\bar{p}$; and
if L > d, encoding the run as a run of L overwrite data bits consisting of m bits of value p and (L - m) bits of value $\bar{p}$ where m = CEIL[(L - d)/d] and the m bits are positioned in the run such that -

(1) there is a bit of value p within d bits of the end of the run,
(2) there is a bit of value p within d + 1 bits of the beginning of the run, and
(3) for m > 1, each of the m bits is within d bits of another of the m bits.

For a run of L bits of value $\bar{x}$ at the end of the coded input data for an overwrite operation, this can be optimally encoded by:

if L ≤ d, encoding the run as a run of L overwrite data bits of value p;
if d < L ≤ 2d, encoding the run as a run of (L + 1) overwrite data bits consisting of L bits of value $\bar{p}$ terminated by one bit of value p; and
if L > 2d, encoding the run as a run of (L + 1) overwrite data bits consisting of a run of L overwrite data bits as defined in condition (c) above terminated by one bit of value p. Thus, runs of L > d bits of value $\bar{x}$ at the end of the coded input data are encoded as runs of (L + 1) overwrite bits, resulting in an extra bit at the end of the overwrite sequence. This extra bit is required to give the correct recorded bit pattern but can be ignored on subsequent data read-out as explained below. By applying these additional encoding conditions for runs of bits of value $\bar{x}$ at the start and end of the coded input data for a write operation, the entire overwrite bit sequence will be optimal in that it will contain the minimum possible number of bits of value p, and hence will require minimum power expenditure in the overwrite operation.

While in general any coding scheme imposing a d ≥ 2 constraint can be employed for the initial coding of the input data, preferred embodiments of the invention utilize codes based on principles of RLL (Run-Length Limited) (d, k) constraint codes. Conventionally in such codes, the (d, k) constraint signifies that successive 1's in the coded bit sequence are separated by at least "d" zeros and at most "k" zeros, where k > d. As explained above however, in different embodiments of the invention the initial input data coding may prohibit two consecutive "1's" (x = 1) or two consecutive "0's" (x = 0) in the coded input data. Thus, while "d" and "k" conventionally represent numbers of zeros, in some embodiments of the invention these constraints may apply to the numbers of "1's" allowed between zeros.

A second aspect of the present invention provides coding apparatus for coding data for storage in a probe-based data storage device wherein data is represented by the presence and absence of pits formed in a storage surface by a probe of the device. The apparatus comprises:

a coder for coding input data to be stored in the device such that successive bits of a value x in the coded input data are separated by at least d bits of value x̄, where d is a predetermined number ≥ 2;
an overwrite pattern generator for generating overwrite data bits by encoding the coded input data bits such that

(a) any bit of value x in the coded input data is encoded as an overwrite data bit of value x,
(b) any bounded run of L ≤ 2d bits of value x̄ in the coded input data is encoded as a run of L overwrite data bits of value x̄, and
(c) any bounded run of L > 2d bits of value x̄ in the coded input data is encoded as a run of L overwrite data bits consisting of n bits of value x and (L - n) bits of value x̄ where n = CEIL[(L - 2d)/d] and the n bits are positioned in the run such that

(c1) there is a bit of value x within d bits of the end of the run,
(c2) there is a bit of value x within 2d + 1 bits of the beginning of the run, and
(c3) for n > 1, each of the n bits is within d bits of another of the n bits.

Similarly, a third aspect of the invention provides coding apparatus for coding data for storage in a probe-based data storage device wherein data is represented by the presence and absence of pits formed in a storage surface by a probe of the device, the apparatus comprising:

a coder for coding input data to be stored in the device such that successive bits of a value x in the coded input data are separated by at least d bits of value x̄, where d is a predetermined number ≥ 2;
an overwrite pattern generator for generating overwrite data bits by encoding the coded input data bits such that

(a) any bit of value x in the coded input data is encoded as an overwrite data bit of value x̄,
(b) any bounded run of L ≤ 2d bits of value x̄ in the coded input data is encoded as a run of L overwrite data bits of value x, and
(c) any bounded run of L > 2d bits of value x̄ in the coded input data is encoded as a run of L overwrite data bits consisting of n bits of value x̄ and (L - n) bits of value x where n = CEIL[(L - 2d)/d] and the n bits are positioned in the run such that

(c1) there is a bit of value x̄ within d bits of the end of the run,
(c2) there is a bit of value x̄ within 2d + 1 bits of the beginning of the run, and
(c3) for n > 1, each of the n bits is within d bits of another of the n bits.

Coding apparatus embodying the second and third aspects of the invention thus generate overwrite data sequences which can be supplied to a probe mechanism of a data storage device for use in overwriting previously-written data. For a given input data sequence, coding apparatus embodying the second aspect of the invention generates an overwrite sequence which is the complement of that produced by apparatus embodying the third aspect of the invention. Coding apparatus embodying the second aspect of the invention is particularly suitable for use with probe-based storage devices in which a bit of value x is written as a pit (p = x). Coding apparatus embodying the third aspect of the invention is particularly suitable for use with probe-based storage devices in which a bit of value x̄ is written as a pit (p = x̄). In each case, the overwrite bit sequence generated by the apparatus can then be supplied directly to the probe mechanism as the data to be written on the storage surface. However, both types of coding apparatus could be used with the opposite type of probe-based storage device (i.e. where a pit represents a bit of the complementary value to that just specified) simply by inverting (i.e. taking the complement of) the overwrite sequence in the storage device to obtain the final write sequence to be written on the storage surface.

The invention also provides methods for storage and recovery of data in a probe-based data storage device wherein data is stored on the storage surface by a method as hereinbefore described, and wherein data read from the storage surface is decoded by one of two methods depending on the relationship between the values p and x in a particular case. If p = x then the original input data is recovered by performing the inverse of the coding which was initially applied to the input data to generate the coded input data. However, if p = $\bar{x}$ then the original input data is recovered by taking the complement of the data read from the storage surface and then performing the inverse of the initial input data coding. The invention similarly provides apparatus for coding and decoding data in a probe-based data storage device, the apparatus comprising coding apparatus as hereinbefore described and a decoder for decoding data read from the storage surface, wherein the decoder is arranged to implement the inverse of the code implemented by the coder of the coding apparatus. Again, depending on the relationship between p and x in a particular device, it may be necessary, prior to implementing the inverse code, to take the complement of the data read from the storage surface. This step could therefore be performed by the decoder itself in some embodiments.

The invention also extends to probe-based data storage devices employing methods and apparatus as hereinbefore described. In particular, a further aspect of the invention provides probe-based data storage apparatus comprising:

a storage surface;

a probe mechanism for storing data on the storage surface by forming pits therein such that data is represented by the presence and absence of pits at bit locations on the surface;

a coder for coding input data to be stored in the device such that successive bits of a value x in the coded input data are separated by at least d bits of value $\bar{x}$, where d is a predetermined number $\geq 2$;

an overwrite pattern generator for generating overwrite data bits by encoding the coded input data bits such that, if a pit represents a bit of value p then

(a) any bit of value x in the coded input data is encoded as an overwrite data bit of value p,

(b) any bounded run of L $\leq$ 2d bits of value $\bar{x}$ in the coded input data is encoded as a run of L overwrite data bits of value $\bar{p}$, and

(c) any bounded run of L > 2d bits of value $\bar{x}$ in the coded input data is encoded as a run of L overwrite data bits consisting of n bits of value p and (L - n) bits of value $\bar{p}$ where n = CEIL[(L - 2d)/d] and the n bits are positioned in the run such that

(c1) there is a bit of value p within d bits of the end of the run,

(c2) there is a bit of value p within 2d + 1 bits of the beginning of the run, and

(c3) for n > 1, each of the n bits is within d bits of another of the n bits;

wherein the probe mechanism is arranged, in use, to overwrite data on the storage surface with the overwrite data bits at a bit spacing such that writing an overwrite data bit of value p can erase an existing bit of value p within d bits of that overwrite data bit.

In general it is to be understood that, where features are described herein with reference to a method embodying the invention, corresponding features may be provided in apparatus embodying the invention, and vice versa.

Embodiments of the invention will now be described, by way of example, with reference to the accompanying drawings in which:

Figure 1 is a schematic block diagram of a probe-based data storage device embodying the invention;

Figure 2 illustrates the principle of the increased surface bit-density available when a d = 2 code is utilized in the Figure 1 embodiment;

Figures 3, 4 and 5 are tables illustrating encoding schemes which can be implemented in the overwrite pattern generator of Figure 1 where d = 2;

Figure 6 illustrates an overwrite operation in the Figure 1 device using an encoding scheme embodying the invention;

Figure 7 is a table comparing an encoding scheme embodying the invention with two encoding schemes disclosed in our earlier European patent application referenced above;

Figure 8 tables run-length probabilities for two encoding methods from our earlier application;

Figures 9 and 10 are tables comparing an embodiment of the invention with the two encoding methods from our earlier application;

Figure 11 is a table illustrating encoding schemes which can be implemented in the overwrite pattern generator of Figure 1 where d = 3;

Figure 12 is a table illustrating encoding schemes for use in an alternative embodiment where the bit value x = 0; and

Figure 13 illustrates an overwrite operation for the alternative embodiment of Figure 12.

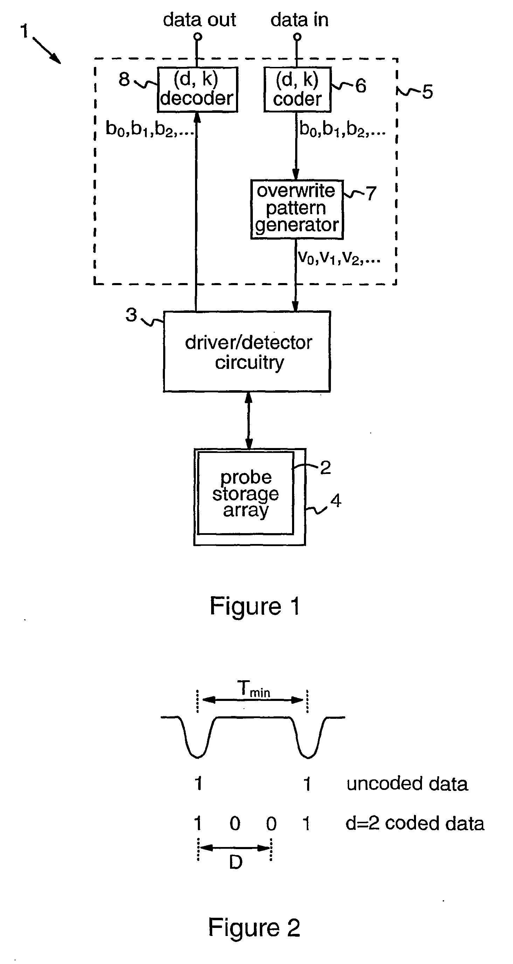

Figure 1 shows a probe-based storage device 1 embodying the invention. The device 1 includes a probe-storage mechanism which, in this embodiment, comprises a Millipede probe-storage array 2, with associated array driver & detector circuitry 3, of the type described in the document referenced above. Under control of driver/detector circuitry 3, the probe array 2 can thus be used to write and read data on the surface of a polymer storage medium 4. The device 1 also includes coding/decoding apparatus which is indicated generally at 5. The coding portion of coding/decoding apparatus 5 consists of a (d, k) coder 6 and an overwrite pattern generator 7 connected as shown between the data input and the array driver/detector circuitry 3. The decoding portion of coding/decoding apparatus 5 consists of a (d, k) decoder 8 connected between the driver/detector circuitry 3 and the data output.

In operation of the device, input data to be stored is supplied to (d, k) coder 6 which implements a (d, k) code with $d \geq 2$ to generate coded input data bits $b_0$, $b_1$, $b_2$,..., etc. The (d, k) coder can be implemented in known manner, the (d, k) code applied ensuring that successive bits of a particular value x in the coded input data are separated by at least d and at most k bits of value $\bar{x}$, where k > d. The (d, k) coded input data $b_0$, $b_1$, $b_2$,..., is supplied to overwrite pattern generator 7 which implements an encoding scheme described further below to generate an overwrite bit sequence $v_0$, $v_1$, $v_2$, ..., etc. This overwrite data $v_0$, $v_1$, $v_2$, ..., is output to array driver circuitry 3 which drives probe array 2 to write the overwrite data on the storage surface 4 with a bit spacing as discussed below.

In the present embodiment, it is assumed that pit formed in the storage surface 4 represents a bit of value "1" (i.e. p =1). Thus, a "1" in the overwrite data supplied to circuitry 3 is written as a pit on storage surface, a "0" in the overwrite data corresponding to "no-pit". In addition, it is assumed that x = 1 in the (d, k) coding process, so that the (d, k) constraints apply to numbers of zeros and successive 1's in the coded input data $b_0$, $b_1$, $b_2$,..., are separated by at least d and at most k zeros. While, in general, any code which imposes a $d \geq 2$ constraint will allow operation of overwrite methods embodying the invention, particular examples of (d, k) codes which may be employed here are the two rate 8/16 (2, 10) codes detailed in our earlier European patent application referenced above, the content of which application is incorporated herein by reference. The following description of operation of the present embodiment will thus focus on the example of a (2, 10) code.

In operation of the embodiment, the effect of the d = 2 constraint is that successive pits to be left in the storage surface after a write operation will be separated by at least two "no-pits". This allows the surface bit density to be increased compared to that for uncoded data as illustrated schematically in Figure 2. This figure shows two successive pits formed in storage surface 4 at the minimum possible spacing $T_{min}$ (i.e. the minimum distance at which writing the second pit will not erase the first pit due to displacement of material). For uncoded data, where adjacent "1's" can occur in the bit sequence, $T_{min}$ thus represents the minimum possible bit spacing for writing data on the storage surface. With a d = 2 constraint however, successive "1's" will always be separated by at least two "0's", so the minimum bit spacing is reduced to $T_{min}/3$ as illustrated. At this bit spacing, it follows that writing an overwrite bit of value 1 will erase a previously-written "1" within $\pm 2$ bit positions of the newly-written overwrite bit due to displacement of material. It is this effect which is exploited in the overwrite system to be described. Thus, the bit-spacing utilized for write operations in the present embodiment is such that writing a "1" will erase a previously-written "1" within $\pm 2$ bit positions of the newly-written "1". Note that this bit spacing need not be the minimum possible bit spacing for d = 2. While the minimum bit spacing is ideally employed in order to achieve maximum data storage density, it actually suffices that the distance D marked in Figure 2 is less than $T_{min}$. More generally, for any value of $d \geq 2$ in overwrite systems embodying the invention, the bit spacing employed in the overwrite operation is such that writing an overwrite data bit of value p can erase an existing bit of value p within d bits of the newly-written overwrite bit. For maximum data storage density, it will generally be desirable to use the minimum possible bit spacing of $T_{min}/(d+1)$.

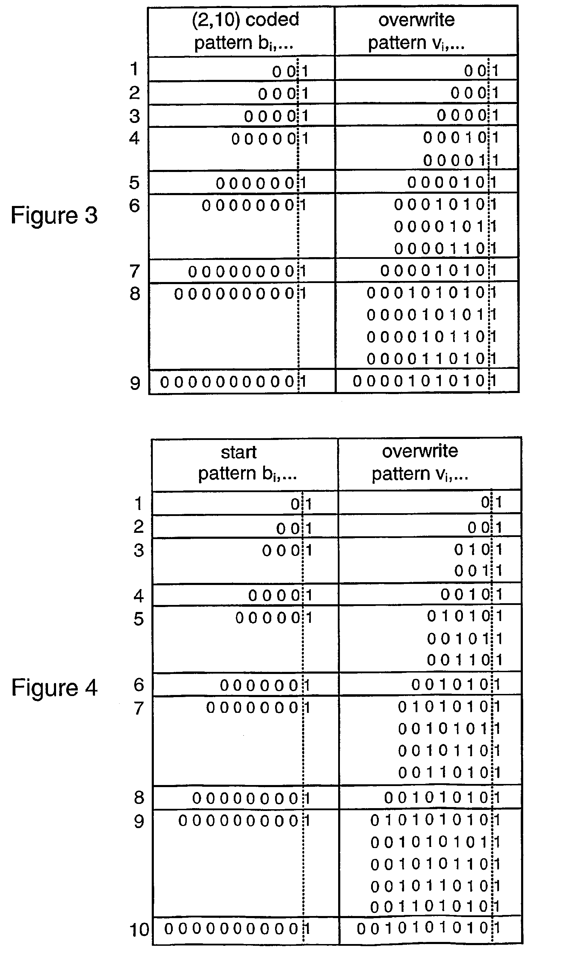

The encoding schemes which can be implemented in the overwrite pattern generator 7 for the (2, 10) code will now be described with reference to Figures 3 to 5. In Figure 3, the left-hand column of the table shows the nine basic run patterns which can appear in the coded input data $b_i$, ... when a (2, 10) code is employed in coder 6. Each of these patterns consists of a run of L zeros, where $2 \leq L \leq 10$, terminated by a "1". The right-hand column of the table shows the overwrite patterns $v_i$, ... which can be used by overwrite pattern generator 7 for encoding each of these $b_i$-patterns. For the $b_i$-patterns numbered 1 to 3 and odd-numbered patterns thereafter, the overwrite patterns are unique. For the remaining $b_i$-patterns, there is a choice of $v_i$-patterns which can be used in overwrite pattern generator 7. According to the encoding rules implemented in the overwrite pattern generator, a bit of value x in the coded input data $b_i$, ... is always encoded as an overwrite bit of value p, where in this embodiment x=p=1. Thus the "1's" at the end of the $b_i$-patterns in the table are encoded as "1's" at the end of the corresponding $v_i$-patterns, as demarcated by the broken lines in the columns. The remaining part of each $b_i$-pattern is a run of L zeros, and these runs are encoded such that one of two conditions is satisfied depending on the value of L. If $L \leq 2d$, i.e. if $L \leq 4$ in this case, then the run of L zeros in the $b_i$-pattern is encoded as a run of L zeros in the $v_i$-pattern. In this example therefore, the first three overwrite patterns in the table are identical to the corresponding $b_i$-patterns. For the remaining $b_i$-patterns L > 2d, and the runs of L zeros are encoded according to a different rule. Each of these runs is encoded as a run of L overwrite bits consisting of n "1's" and (L - n) zeros, where the number n is given by $n = \text{CEIL}[(L - 2d)/d]$. Thus: for 2d < L < 3d, n=1; for 3d < L $\leq$ 4d, n=2; and so on. Moreover, the position of the n "1's" in the run of overwrite bits is important. Consideration of the runs shown in the table shows that, in all cases: there is a "1" within d bits of the end of the run; there is a "1" within 2d + 1 bits of the beginning of the run; and if n > 1, each of the n "1's" is within d bits of another of the n "1's".

The $v_i$-patterns of Figure 3 apply where the corresponding $b_i$-patterns are preceded by a "1" in the coded input data sequence, so that the runs of L zeros in the $b_i$-patterns are bounded runs. This will usually be the case since the preceding $b_i$-pattern in the coded input data sequence will terminate in a "1". However, the coded input data may start with a run of zeros which is not preceded by a "1", and/or may end with a run of zeros which is not terminated by a "1". The encoding conditions for such start and end patterns will be explained below, but it is useful first to consider the basic patterns of Figure 3 since the operating principle of the overwrite system can be seen from these patterns. The bits of a $v_i$-pattern output by overwrite pattern generator 7 will be written sequentially on storage surface 4, starting with the left-hand bit in the Figure 3 representation, and old data may be overwritten in this process. Recall that the bit spacing for the write operation is such that writing a "1" will erase a previously-written "1" within d bits, here 2 bits, of the newly-written "1". Thus, the first two bits of a $v_i$-pattern in Figure 3 can always be zero since any "1" in the old data at these bit positions will have been erased by writing the terminal 1 of the preceding $v_i$-pattern. It can also be seen that the "1's" are positioned in the $v_i$-patterns such that, as writing of a $v_i$-pattern continues, any "1's" in the old data being overwritten will be erased by one of the "1's" in the $v_i$-pattern. Moreover, where there is more than one "1" in the $v_i$-pattern, all but the terminal "1" will be erased by writing a subsequent "1" in the $v_i$-pattern. The resulting bit pattern recorded on the storage surface will thus be the appropriate $b_i$-pattern.

The possible $b_i$-patterns at the start of a coded input data sequence for a write operation are shown in Figure 4 together with the corresponding $v_i$-patterns which can be used in overwrite pattern generator 7. For the $b_i$-patterns 1 and 2 and even-numbered patterns thereafter, the overwrite patterns are unique, whereas, for the remaining $b_i$-patterns, there is a choice of $v_i$-patterns which can be used in overwrite pattern generator 7. Each of the $b_i$-patterns consists of a run of L zeros, where $1 \leq L \leq 10$, terminated by a "1". According to the general rule that "1's" in the coded input data are always encoded as "1's" in the overwrite data, the "1's" at the end of the $b_i$-patterns in the figure are encoded as "1's" at the end of the corresponding $v_i$-patterns, as demarcated by the broken lines in the columns. The remaining part of each $b_i$-pattern is a run of L zeros, and these runs are not bounded runs since there is no preceding $b_i$-pattern which terminates in a "1". These L-bit runs are encoded in the $v_i$-patterns such that one of two conditions is satisfied depending on the value of L. For $L \leq d$, i.e. $L \leq 2$ here, the run is encoded as a run of L zeros in the $v_i$-pattern. However, each run for which L > d is encoding as a run of L overwrite data bits consisting of m "1's" and (L - m) zeros, where m = CEIL[(L - d)/d]. Thus for $d < L \leq 2d$, m=1; for $2d < L \leq 3d$, m=2; and so on. In addition, consideration of these L-bit runs in the $v_i$-patterns shows that, in each case, the m bits are positioned so that: there is a "1" within d bits of the end of the run; there is a "1" within d + 1 bits of the beginning of the run; and, for m > 1, each of the m bits is within d bits of another of the m bits. Comparing the resulting $v_i$-patterns for $b_i$-patterns 3 to 10 here with those for the same $b_i$-patterns in Figure 3 shows that the $v_i$-patterns in Figure 4 contain an extra "1" within d+1 bits of the beginning of the pattern. This is to deal with the fact that a "1" in old data overwritten by the first two bits of the $v_i$-pattern will not have been erased by a preceding $v_i$-pattern, since the current $v_i$-pattern is the beginning of the overwrite data sequence.

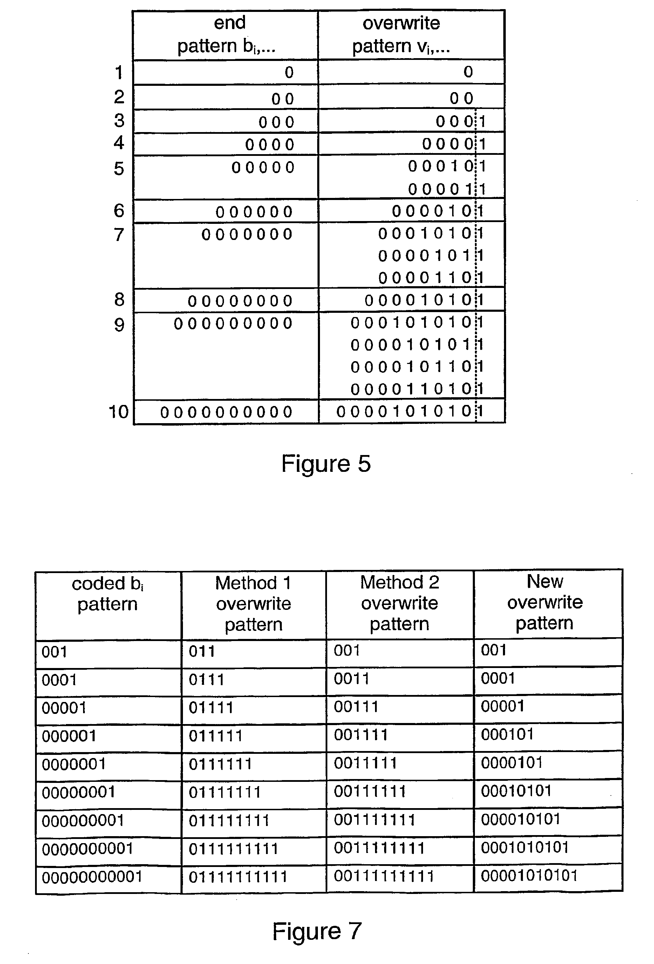

Insofar as the coded input data sequence for a write operation may end with a $b_i$-pattern other than those of Figure 3, the possible end-patterns are shown in Figure 5 together with the corresponding $v_i$-patterns which can be used in overwrite pattern generator 7. Each of these $b_i$-patterns consists of a run of L zeros, where $1 \leq L \leq 10$, and once again these runs are not bounded runs since there is no terminal "1" in this case. The conditions for encoding these runs in the $v_i$-patterns again depends on the value of L. If $L \leq d$, i.e. $L \leq 2$ here, the run is encoded in the $v_i$-pattern as a run of L zeros. However, runs 3 to 10 in Figure 5 (for which L > d) are encoded identically to $b_i$-patterns 2 to 9 respectively of Figure 3. As a consequence, $v_i$-patterns 3 to 10 in Figure 5 contain an extra bit compared to their corresponding $b_i$-patterns. This extra bit is the "1" at the end of the pattern and is required to ensure that the resulting recorded bit pattern, excluding the extra bit itself, is the correct $b_i$-pattern.

The tables of Figure 3 to 5 give all the possible $v_i$-patterns which can be utilized in overwrite pattern generator 7 for the (2, 10) code and which contain the minimal possible number of "1's" necessary to achieve direct overwriting. Where the $v_i$-pattern for a given $b_i$-pattern is not unique, any one of the equivalent $v_i$-patterns can be used, so that a different $v_i$-pattern might be used for the same $b_i$-pattern at different times. For simplicity of implementation, however, the overwrite pattern generator will generally be configured to encode a given $b_i$-pattern as a given $v_i$-pattern. In a preferred embodiment, therefore, the overwrite pattern generator 7 encodes each $b_i$-pattern in Figures 3 to 5 as the corresponding $v_i$-pattern which is listed first in the tables where there is a choice. These $v_i$-patterns contain a simple repeating "01" sequence as shown in the figures. As the coded input data is received in operation, the overwrite pattern generator 7 operates as a kind of look-ahead encoder in that it finds the position of each successive "1" in the input bit stream. Each "1" marks the end of the current $b_i$-pattern, this being encoded as the appropriate $v_i$-pattern which is then output to the array driver 3. If there is no "1" at the end of the coded input data for a write operation, the overwrite pattern generator uses the appropriate $v_i$-pattern from Figure 5 as the last $v_i$-pattern. In some embodiments, the overwrite pattern generator may be implemented in software, and suitable software will be apparent to those skilled in the art from the description herein. In other embodiments, the overwrite pattern generator may be implemented in hardware or a combination of hardware and software, e.g. by hardwired logic gates or as a lookup table for example.

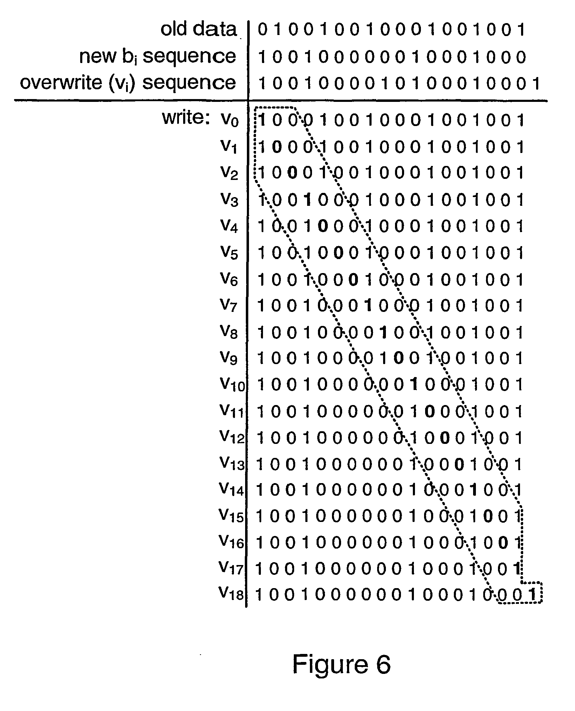

Figure 6 demonstrates the overwrite operation by way of a worked example for the case where the $v_i$-patterns used in overwrite pattern generator 7 are the first-listed patterns in Figures 3 to 5. The bit sequence at the top of this figure represents an old data pattern which is to be overwritten. The second bit sequence represents a new data pattern to be recorded, i.e. the coded input data $b_0$, $b_1$, $b_2$,..., output by (d, k) coder 6. The third bit sequence is the overwrite pattern $v_0$, $v_1$, $v_2$,..., generated by overwrite pattern generator 7 from the coded input data. In this simplistic example, the data to be recorded consists of only 18 bits, though in practice a line of data for a write operation will typically be much longer. Each of the nineteen bit patterns beneath the overwrite sequence in the figure shows the bit pattern as recorded on the storage surface after writing successive bits of the overwrite sequence. Thus, the first of these shows the recorded pattern after $v_0$ is written, the second shows the recorded pattern after $v_1$ is written, and so on. In each pattern, the newly-written bit is shown in bold. Since writing a "1" can erase a previously-written "1" within $\pm 2$ bits of the write position, each write operation can potentially affect the values of five consecutive bits (decreasing to three consecutive bits towards the beginning and end of the write sequence) within the area bounded by broken lines in the figure. As the write operation progresses, the old data is gradually transformed into the new $b_i$ sequence. Once the extra bit $v_{18}$ at the end of the overwrite sequence has been written, it can be seen that the recorded 18-bit sequence prior to this extra bit is the required $b_i$ sequence. Note from this example that it can never be necessary to erase two "1's" both to the left or both to the right of the write position, since two consecutive "1's" are prohibited by the (d, k) code. Also, when a "1" is written at the position of an existing "1", then the two existing bits on each side of this position are necessarily zeros, so that no bits need to be erased in this situation.

With regard to the extra bit required in some cases, in practice guard bands will typically be provided around writable sectors on the storage medium to ensure there is space at the beginning and end of a row and avoid interference between data in different sectors. When data is read-back from the storage medium, extra bits in guard bands are ignored, and the $b_i$ sequence is simply supplied by detector circuitry 3 to the (d, k) decoder 8. This decoder implements the inverse of the (d, k) code performed by coder 6, whereby the original input data is recovered as output data.

It will be seen that the above system allows old data to be directly overwritten, avoiding the need to erase data before a write operation. Moreover, this is achieved with substantially less power expenditure than with methods disclosed in our earlier European patent application referenced above. That application describes two basic overwrite methods, referred to in the application as "method 1" and "method 2". The overwrite patterns generated by those methods for the basic $b_i$-patterns of Figure 3 are listed in the table of Figure 7. The last column of this table lists the overwrite patterns for the simple embodiment of the present invention discussed above. Comparison of these patterns shows that the new technique provides overwrite patterns containing far fewer "1's" than those of the earlier methods. Indeed, the new overwrite patterns contain the minimum possible number of "1's" required to achieve direct overwriting. This translates to optimal power consumption in the overwrite operation. The significance of the power saving here is demonstrated by the following analysis.

Let $P_w$ be the power required for a single write operation (i.e. writing a single "1" in the above example), and $p_i$ be the probability of a run-length of i consecutive zeros both preceded and followed by a "1" (i.e. a bounded run of $i$ zeros). Taking the (2, 10) code discussed above as an example, then, from Figure 7, the average power dissipation for each the three methods is given by:

$$P_{method1} = P_w \sum_{i=2}^{10} i.p_i \tag{1}$$

$$P_{method2} = P_w \sum_{i=2}^{10} (i-1)p_i \tag{2}$$

$$P_{new} = P_w(p_2 + p_3 + p_4 + 2p_5 + 2p_6 + 3p_7 + 3p_8 + 4p_9 + 4p_{10}) \tag{3}$$

The power required for any particular overwrite method should be measured against the corresponding power for a basic write operation on a clean storage surface. The power required for such a basic write operation is:

$$P_{write} = P_w \sum_{i=2}^{10} 1 \cdot p_i = P_w \tag{4}$$

since $\sum_{i=2}^{10} p_i = 1$. The reduction in power dissipation through using one method over another can be quantified by the "power dissipation reduction factor" $f_{A,B}$, where:

$$f_{A,B} = \frac{P_{methodA}}{P_{methodB}} \tag{5}$$

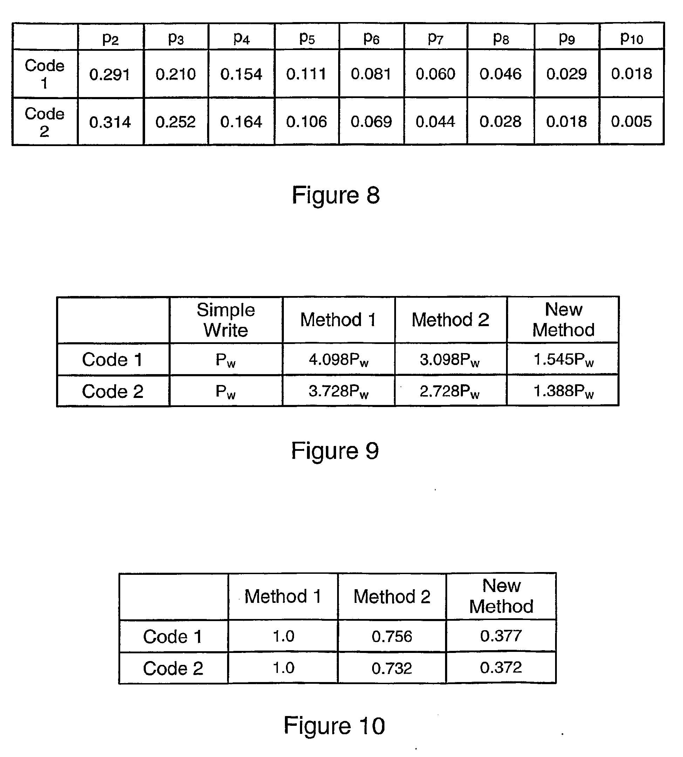

The power advantages of one method over another depend on the run-length probabilities of the specific code used. The run-length probabilities have been estimated for the two rate 8/16 (2,10) codes disclosed in our earlier application (referred to as "Code 1" and "Code 2") and shown in the table of Figure 8. Based on these probabilities, the power dissipation of the various methods for both codes is indicated in the table of Figure 9. The power dissipation reduction factors for the three overwrite methods, with Method 1 as a reference, are shown in the table of Figure 10. It can be seen from these tables that, when using Code 2 for example, Method 2 requires 73.2% of the power required by Method 1, whereas the new method requires only 37.2% of this power. Compared to a simple write operation on a clean substrate, the new method requires only about 39% more power, whereas Method 2 requires about 173% more power. The new overwrite system thus offers a dramatic saving in power consumption over the earlier overwrite methods.

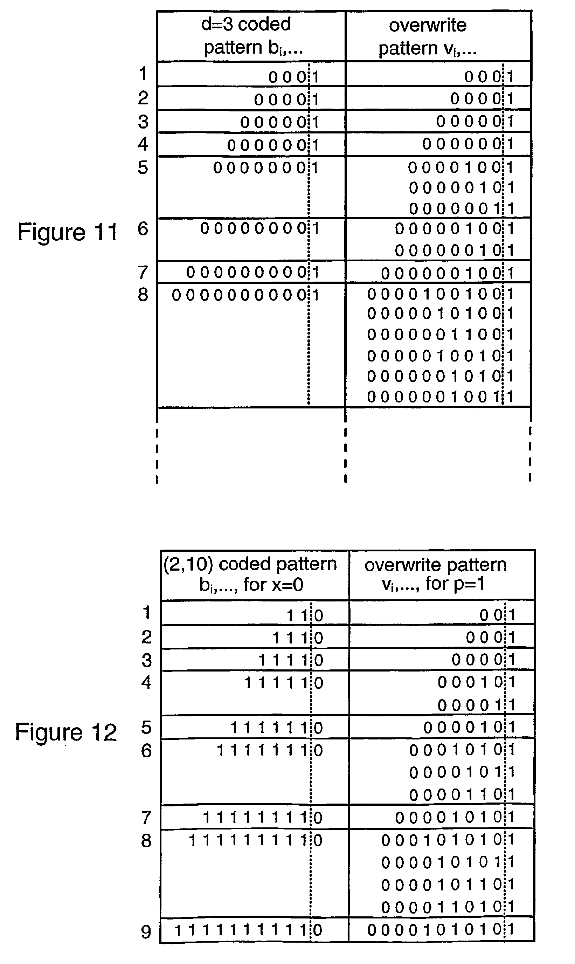

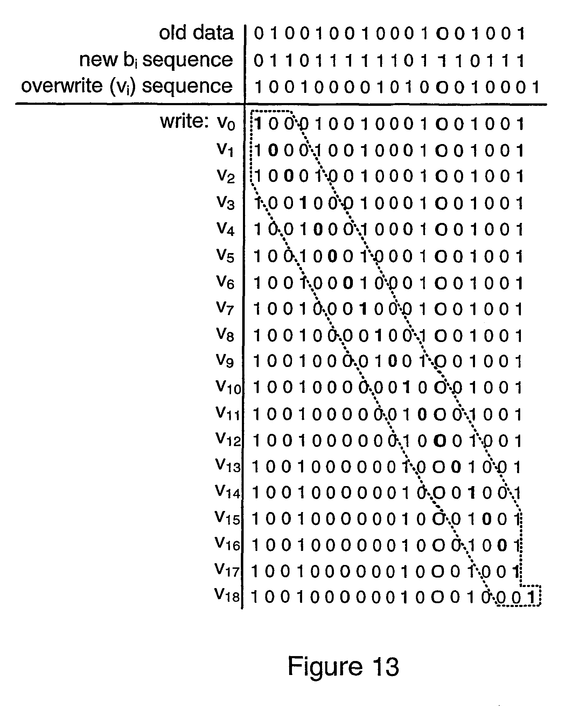

While operation of the overwrite system has been illustrated above for a (2,10) code, by applying the general encoding rules for generating overwrite patterns the system can be employed with any $d \geq 2$ code. By way of example, Figure 11 shows the overwrite patterns for basic $b_i$-patterns (equivalent to those of Figure 3) with a d=3 code. These can of course be continued for any value of k. Indeed, while the k-constraint is desirable for timing recovery purposes, a k constraint is not in theory necessary for operation of the overwrite technique. In addition, while the value x=p=1 in the above example, the system can be applied with either value of x and either value of p using the generalized rules set out earlier. By way of example, Figure 12 shows the equivalent table to Figure 3 for an alternative embodiment in which x = 0 and p = 1. In embodiments where x = p, whether this value is "0" or "1", the result of an overwrite operation is to record the coded input data $b_0, b_1, b_2,...,$ on the storage surface as in the example above. However, where x = $\overline{p}$ as in Figure 12, then the overwrite operation will record the complement of the coded input data, i.e. $\overline{b}_0, \overline{b}_1, \overline{b}_2,..., $ . This is demonstrated in Figure 13 which shows the equivalent example to Figure 6 but in which it is assumed that x = 0 and p =1. Thus, in embodiments where x = $\overline{p}$, an inverter is provided between drive circuitry 3 and decoder 8 in Figure 1, whereby data read from the storage surface is decoded by taking the complement of this data and then performing the inverse (d, k) coding.

While the storage device 1 employs a Millipede probe storage array in the particular embodiment described, different probe mechanisms may be employed in other probe-based storage devices embodying the invention. Moreover, embodiments of the invention could use write-pattern selection as described in our earlier application, whereby a controller selects either the overwrite data or the coded input data as the write pattern depending on whether the write pattern is to overwrite old data or is to be written on a clean area of the storage surface. However, since embodiments of the invention have reduced overwrite power requirements comparable to those for basic write operations on clean surfaces, write-pattern selection is less relevant here, and the simple system described above will generally be preferred. Many other changes and modifications can of course be made to the specific embodiments described above without departing from the scope of the invention.

## Claims

**1.** A method for overwriting data in a probe-based data storage device (1) wherein data is represented by the presence and absence of pits formed in a storage surface (4) by a probe of the device, the method comprising:

coding input data such that successive bits of a value x in the coded input data ($b_0, b_1, b_2,...,$) are separated by at least d bits of value $\overline{x}$, where d is a predetermined number $\geq 2$;
generating overwrite data bits ($v_0, v_1, v_2,...,$) by encoding the coded input data bits ($b_0, b_1, b_2,...,$) such that, if a pit represents a bit of value p in the data storage device (1), then

(a) any bit of value x in the coded input data ($b_0$, $b_1$, $b_2$,...,) is encoded as an overwrite data bit of value p,
(b) any bounded run of L ≤ 2d bits of value $\overline{x}$ in the coded input data ($b_0$, $b_1$, $b_2$,...,) is encoded as a run of L overwrite data bits of value $\overline{p}$, and
(c) any bounded run of L > 2d bits of value $\overline{x}$ in the coded input data ($b_0$, $b_1$, $b_2$,..., ) is encoded as a run of L overwrite data bits consisting of n bits of value p and (L - n) bits of value $\overline{p}$ where n = CEIL[(L - 2d)/d] and the n bits are positioned in the run such that

> (c1) there is a bit of value p within d bits of the end of the run,
> (c2) there is a bit of value p within 2d + 1 bits of the beginning of the run, and
> (c3) for n > 1, each of the n bits is within d bits of another of the n bits; and

overwriting data on the storage surface (4) with the overwrite data bits ($v_0$, $v_1$, $v_2$,...,) at a bit spacing such that writing an overwrite data bit of value p can erase an existing bit of value p within d bits of that overwrite data bit.

2. A method as claimed in claim 1 including, for a run of L bits of value $\overline{x}$ at the start of the coded input data ($b_0$, $b_1$, $b_2$,...,) for an overwrite operation:

> if L ≤ d, encoding the run as a run of L overwrite data bits of value $\overline{p}$; and
> if L > d, encoding the run as a run of L overwrite data bits consisting of m bits of value p and (L - m) bits of value $\overline{p}$ where m = CEIL[(L - d)/d] and the m bits are positioned in the run such that

> > (1) there is a bit of value p within d bits of the end of the run,
> > (2) there is a bit of value p within d + 1 bits of the beginning of the run, and
> > (3) for m > 1, each of the m bits is within d bits of another of the m bits.

3. A method as claimed in claim 1 or claim 2 including, for a run of L bits of value $\overline{x}$ at the end of the coded input data ($b_0$, $b_1$, $b_2$,...,) for an overwrite operation:

> if L ≤ d, encoding the run as a run of L overwrite data bits of value $\overline{p}$;
> if d < L ≤ 2d, encoding the run as a run of (L + 1) overwrite data bits consisting of L bits of value p terminated by one bit of value p; and
> if L > 2d, encoding the run as a run of (L + 1) overwrite data bits consisting of a run of L overwrite data bits according to condition (c) of claim 1 terminated by one bit of value p.

4. A method as claimed in any preceding claim wherein p = 1.

5. A method as claimed in any preceding claim wherein x = 1.

6. A method as claimed in any preceding claim wherein d = 2.

7. A method as claimed in any preceding claim wherein the input data is coded such that successive bits of a value x in the coded input data ($b_0$, $b_1$, $b_2$,...,) are separated by at least d and at most k bits of value $\overline{x}$, where k is a predetermined number > d.

8. A method as claimed in claim 7 wherein d = 2 and k = 10.

9. A method for storage and recovery of data in a probe-based data storage device (1) wherein data is represented by the presence and absence of pits formed in a storage surface (4) by a probe of the device, the method comprising storing data on the storage surface (4) by a method as claimed in any preceding claim, and decoding data read from the storage surface (4) by:

> - if said value x equals said value p in the data storage device (1), performing the inverse of the coding applied to the input data to generate said coded input data ($b_0$, $b_1$, $b_2$,...,); and
> - if said value $\overline{x}$ equals said value p in the data storage device, taking the complement of the data read from the storage surface and then performing the inverse of the coding applied to the input data to generate said coded input data ($b_0$, $b_1$, $b_2$,...,);

thereby to recover said input data.

**10.** Coding apparatus for coding data for storage in a probe-based data storage device (1) wherein data is represented by the presence and absence of pits formed in a storage surface (4) by a probe of the device, the apparatus comprising:

a coder (6) for coding input data to be stored in the device such that successive bits of a value x in the coded input data ($b_0$, $b_1$, $b_2$,...,) are separated by at least d bits of value $\bar{x}$, where d is a predetermined number $\geq 2$;
an overwrite pattern generator (7) for generating overwrite data bits ($v_0$, $v_1$, $v_2$,...,) by encoding the coded input data bits ($b_0$, $b_1$, $b_2$,...,) such that

(a) any bit of value x in the coded input data ($b_0$, $b_1$, $b_2$,...,) is encoded as an overwrite data bit of value x,
(b) any bounded run of L $\leq$ 2d bits of value $\bar{x}$ in the coded input data ($b_0$, $b_1$, $b_2$,...,) is encoded as a run of L overwrite data bits of value $\bar{x}$, and
(c) any bounded run of L > 2d bits of value $\bar{x}$ in the coded input data ($b_0$, $b_1$, $b_2$,...,) is encoded as a run of L overwrite data bits consisting of n bits of value x and (L - n) bits of value $\bar{x}$ where n = CEIL[(L - 2d)/d] and the n bits are positioned in the run such that

(c1) there is a bit of value x within d bits of the end of the run,
(c2) there is a bit of value x within 2d + 1 bits of the beginning of the run, and
(c3) for n > 1, each of the n bits is within d bits of another of the n bits.

**11.** Coding apparatus for coding data for storage in a probe-based data storage device (1) wherein data is represented by the presence and absence of pits formed in a storage surface (4) by a probe of the device, the apparatus comprising:

a coder (6) for coding input data to be stored in the device (1) such that successive bits of a value x in the coded input data ($b_0$, $b_1$, $b_2$,...,) are separated by at least d bits of value $\bar{x}$, where d is a predetermined number $\geq 2$;
an overwrite pattern generator (7) for generating overwrite data bits ($v_0$, $v_1$, $v_2$,...,) by encoding the coded input data bits ($b_0$, $b_1$, $b_2$, ...,) such that

(a) any bit of value x in the coded input data ($b_0$, $b_1$, $b_2$,...,) is encoded as an overwrite data bit of value $\bar{x}$,
(b) any bounded run of L $\leq$ 2d bits of value $\bar{x}$ in the coded input data ($b_0$, $b_1$, $b_2$,...,) is encoded as a run of L overwrite data bits of value x, and
(c) any bounded run of L > 2d bits of value $\bar{x}$ in the coded input data ($b_0$, $b_1$, $b_2$,...,) is encoded as a run of L overwrite data bits consisting of n bits of value $\bar{x}$ and (L - n) bits of value x where n = CEIL[(L - 2d)/d] and the n bits are positioned in the run such that

(c1) there is a bit of value $\bar{x}$ within d bits of the end of the run,
(c2) there is a bit of value $\bar{x}$ within 2d + 1 bits of the beginning of the run, and
(c3) for n > 1, each of the n bits is within d bits of another of the n bits.

**12.** Apparatus (5) for coding and decoding data in a probe-based data storage device (1) wherein data is represented by the presence and absence of pits formed in a storage surface (4) by a probe of the device, the apparatus (5) comprising:

coding apparatus as claimed in claim 10 or claim 11; and
a decoder (8) for decoding data read from the storage surface (4), the decoder (8) being arranged to implement the inverse of the code implemented by said coder (6).

**13.** Probe-based data storage apparatus (1) comprising:

a storage surface (4);
a probe mechanism (2) for storing data on the storage surface (4) by forming pits therein such that data is represented by the presence and absence of pits at bit locations on the surface (4);
a coder (6) for coding input data to be stored in the device such that successive bits of a value x in the coded input data ($b_0$, $b_1$, $b_2$,...,) are separated by at least d bits of value $\bar{x}$, where d is a predetermined number $\geq 2$;
an overwrite pattern generator (7) for generating overwrite data bits ($v_0$, $v_1$, $v_2$,...,) by encoding the coded input data bits ($b_0$, $b_1$, $b_2$,...,) such that, if a pit represents a bit of value p then

(a) any bit of value x in the coded input data ($b_0$, $b_1$, $b_2$,...,) is encoded as an overwrite data bit of value p,
(b) any bounded run of L $\leq$ 2d bits of value $\bar{x}$ in the coded input data ($b_0$, $b_1$, $b_2$,...,) is encoded as a run of L overwrite data bits of value $\bar{p}$, and

(c) any bounded run of L > 2d bits of value $\bar{x}$ in the coded input data ($b_0$, $b_1$, $b_2$,...,) is encoded as a run of L overwrite data bits consisting of n bits of value p and (L - n) bits of value $\bar{p}$ where n = CEIL[(L - 2d)/d] and the n bits are positioned in the run such that

(c1) there is a bit of value p within d bits of the end of the run,
(c2) there is a bit of value p within 2d + 1 bits of the beginning of the run, and
(c3) for n > 1, each of the n bits is within d bits of another of the n bits;

wherein the probe mechanism (2) is arranged, in use, to overwrite data on the storage surface (4) with the overwrite data bits ($v_0$, $v_1$, $v_2$,...,) at a bit spacing such that writing an overwrite data bit of value p can erase an existing bit of value p within d bits of that overwrite data bit.

14. Apparatus as claimed in claim 13 wherein the overwrite pattern generator (7) is arranged for encoding a run of L bits of value $\bar{x}$ at the start of the coded input data ($b_0$, $b_1$, $b_2$,...,) for an overwrite operation by:

if L ≤ d, encoding the run as a run of L overwrite data bits of value $\bar{p}$; and
if L > d, encoding the run as a run of L overwrite data bits consisting of m bits of value p and (L - m) bits of value $\bar{p}$ where m = CEIL[(L - d)/d] and the m bits are positioned in the run such that

(1) there is a bit of value p within d bits of the end of the run,
(2) there is a bit of value p within d + 1 bits of the beginning of the run, and
(3) for m > 1, each of the m bits is within d bits of another of the m bits.

15. Apparatus as claimed in claim 13 or claim 14 wherein the overwrite pattern generator (7) is arranged for encoding a run of L bits of value $\bar{x}$ at the end of the coded input data ($b_0$, $b_1$, $b_2$, ...,) for an overwrite operation by:

if L ≤ d, encoding the run as a run of L overwrite data bits of value $\bar{p}$;
if d < L ≤ 2d, encoding the run as a run of (L + 1) overwrite data bits consisting of L bits of value p terminated by one bit of value p; and
if L > 2d, encoding the run as a run of (L + 1) overwrite data bits consisting of a run of L overwrite data bits according to condition (c) of claim 13 terminated by one bit of value p.

16. Apparatus as claimed in any one of claims 13 to 15 including a decoder (8) for decoding data read from the storage surface (4), the decoder (8) being arranged to recover the input data by:

if said value x equals said value p, performing the inverse of the coding applied to the input data to generate said coded input data ($b_0$, $b_1$, $b_2$, ...,); and
if said value $\bar{x}$ equals said value p, taking the complement of the data read from the storage surface (4) and then performing the inverse of the coding applied to the input data to generate said coded input data ($b_0$, $b_1$, $b_2$,...,).

17. Apparatus as claimed in any one of claims 13 to 16 wherein p = 1.

18. Apparatus as claimed in any one of claims 13 to 17 wherein the probe mechanism (2) comprises a plurality of individually-addressable probes for writing data on the storage surface (4).

19. Apparatus as claimed in any one of claims 10 to 18 wherein x = 1.

20. Apparatus as claimed in any one of claims 10 to 19 wherein d = 2.

21. Apparatus as claimed in any one of claims 10 to 20 wherein the coder (6) is arranged to code the input data such that successive bits of a value x in the coded input data ($b_0$, $b_1$, $b_2$,...,) are separated by at least d and at most k bits of value $\bar{x}$, where k is a predetermined number > d.

22. Apparatus as claimed in claim 21 wherein d = 2 and k = 10.

**EP 1 516 336 B1**

**Patentansprüche**

1. Verfahren zum Überschreiben von Daten in einer auf einer Sonde beruhenden Datenspeichereinheit (1), wobei Daten durch das Vorhandensein oder das Fehlen von Vertiefungen (Pits), die in einer Speicheroberfläche (4) durch eine Sonde der Vorrichtung ausgebildet werden, dargestellt werden, wobei das Verfahren Folgendes umfasst:

   Codieren von Eingabedaten in der Weise, dass aufeinander folgende Bits eines Wertes x in den codierten Eingabedaten ($b_0$, $b_1$, $b_2$, ...,) durch wenigstens d Bits des Wertes $\overline{x}$ getrennt sind, wobei d eine vorgegebene Zahl $\geq 2$ ist;
   Erzeugen von Überschreibdatenbits ($v_1$, $v_2$, $v_3$, ..., ) durch Codieren der codierten Eingabedatenbits ($b_0$, $b_1$, $b_2$,...,) in der Weise, dass dann, wenn eine Vertiefung ein Bit des Wertes p in der Datenspeichervorrichtung (1) darstellt, Folgendes gilt:

   (a) alle Bits des Wertes x in den codierten Eingabedaten ($b_0$, $b_1$, $b_2$, ..., ) werden als Überschreibdatenbits des Wertes p codiert;
   (b) jede begrenzte Folge von L $\leq$ 2d Bits des Wertes $\overline{x}$ in den codierten Eingabedaten ($b_0$, $b_1$, $b_2$,...,) wird als eine Folge von L Überschreibdatenbits des Wertes $\overline{p}$ codiert, und
   (c) jede begrenzte Folge von L > 2d Bits des Wertes $\overline{x}$ in den codierten Eingabedaten ($b_0$, $b_1$, $b_2$,...,) wird als eine Folge von L Überschreibdatenbits codiert, die aus n Bits des Wertes p und (L - n) Bits des Wertes $\overline{p}$ bestehen, wobei n = CEIL[(L - 2d)/d] und die n Bits in der Folge so positioniert sind, dass gilt:

   (c1) es gibt ein Bit des Wertes p innerhalb von d Bits am Ende der Folge,
   (c2) es gibt ein Bit des Wertes p innerhalb von 2d + 1 Bits am Anfang der Folge und
   (c3) für n > 1 liegt jedes der n Bits innerhalb von d Bits, die von den n Bits verschieden sind; und

   Überschreiben von Daten auf der Speicheroberfläche (4) mit den Überschreibdatenbits ($v_1$, $v_2$, $v_3$, ..., ) bei einem derartigen Bitabstand, dass ein Schreiben eines Überschreibdatenbits des Wertes p ein vorhandenes Bit des Wertes p innerhalb von d Bits dieses Überschreibdatenbits löschen kann.

2. Verfahren nach Anspruch 1, das für eine Folge von L Bits des Wertes $\overline{x}$ am Beginn der codierten Eingabedaten ($b_0$, $b_1$, $b_2$,...,) für eine Überschreiboperation Folgendes enthält:

   wenn L $\leq$ d, Codieren der Folge als eine Folge von L Überschreibdatenbits des Wertes $\overline{p}$; und
   wenn L > d, Codieren der Folge als eine Folge von L Überschreibdatenbits, die aus m Bits des Wertes p und (L - m) Bits des Wertes $\overline{p}$ bestehen, wobei m = CEIL[(L - d)/d] und die m Bits in der Folge derart positioniert sind, dass Folgendes gilt:

   (1) es gibt ein Bit des Wertes p innerhalb von d Bits am Ende der Folge,
   (2) es gibt ein Bit des Wertes p innerhalb von d + 1 Bits am Anfang der Folge und
   (3) für m > 1 liegt jedes der m Bits innerhalb von d Bits, die von den m Bits verschieden sind.

3. Verfahren nach Anspruch 1 oder 2, das für eine Folge von L Bits des Wertes $\overline{x}$ am Ende der codierten Eingabedaten ($b_0$, $b_1$, $b_2$,...,) für eine Überschreiboperation Folgendes enthält:

   wenn L $\leq$ d, Codieren der Folge als eine Folge von L Überschreibdatenbits des Wertes $\overline{p}$;
   wenn d < L $\leq$ 2d, Codieren der Folge als eine Folge von (L + 1) Überschreibdatenbits, die aus L Bits des Wertes $\overline{p}$ bestehen, die durch ein Bit des Wertes p abgeschlossen werden; und
   wenn L > 2d, Codieren der Folge als eine Folge von (L + 1) Überschreibdatenbits, die aus einer Folge von L Überschreibdatenbits gemäß der Bedingung (c) von Anspruch 1 bestehen und durch ein Bit des Wertes p abgeschlossen werden.

4. Verfahren nach einem vorhergehenden Anspruch, wobei p = 1.

5. Verfahren nach einem vorhergehenden Anspruch, wobei x = 1.

6. Verfahren nach einem vorhergehenden Anspruch, wobei d = 2.

7. Verfahren nach einem vorhergehenden Anspruch, wobei die Eingabedaten in der Weise codiert sind, dass aufeinander folgende Bits eines Wertes x in den codierten Eingabedaten ($b_0$, $b_1$, $b_2$,...,) durch wenigstens d und höchstens k Bits des Wertes $\overline{x}$ getrennt sind, wobei k eine vorgegebene Zahl > d ist.

8. Verfahren nach Anspruch 7, wobei d = 2 und k = 10.

9. Verfahren zum Speichern und Wiederherstellen von Daten in einer auf einer Sonde beruhenden Datenspeichervorrichtung (1), wobei Daten durch das Vorhandensein oder das Fehlen von Vertiefungen, die durch eine Sonde der Vorrichtung in einer Speicheroberfläche (4) ausgebildet werden, dargestellt werden, wobei das Verfahren das Speichern von Daten auf der Speicheroberfläche (4) durch ein Verfahren nach einem vorhergehenden Verfahren und das Decodieren von Daten, die von der Speicheroberfläche gelesen werden, umfasst, durch:

wenn der Wert x gleich dem Wert p in der Datenspeichervorrichtung (1) ist, Ausführen der Umkehrung der Codierung, die auf die Eingabedaten angewendet wird, um die codierten Eingabedaten ($b_0$, $b_1$, $b_2$,..., ) zu erzeugen; und
wenn der Wert $\overline{x}$ gleich dem Wert p in der Datenspeichervorrichtung (1) ist, Verwenden des Komplements der von der Speicheroberfläche gelesenen Daten und anschließend Ausführen der Umkehrung der Codierung, die auf die Eingabedaten angewendet wird, um die codierten Eingabedaten ($b_0$, $b_1$, $b_2$,...,) zu erzeugen;
um dadurch die Eingabedaten wiederherzustellen.

10. Codiervorrichtung zum Codieren von Daten zur Speicherung in einer auf einer Sonde beruhenden Datenspeichervorrichtung (1), wobei Daten durch das Vorhandensein oder das Fehlen von Vertiefungen (Pits), die in einer Speicheroberfläche (4) durch eine Sonde der Vorrichtung ausgebildet werden, dargestellt werden, wobei die Vorrichtung Folgendes umfasst:

eine Codiereinrichtung (6) zum Codieren von Eingabedaten, die in der Einheit gespeichert werden sollen, in der Weise, dass aufeinander folgende Bits eines Wertes x in den codierten Eingabedaten ($b_0$, $b_1$, $b_2$,...,) durch wenigstens d Bits des Wertes $\overline{x}$ getrennt sind, wobei d eine vorgegebene Zahl $\geq 2$ ist;
ein Überschreibmustergenerator (7) zum Erzeugen von Überschreibdatenbits ($v_1$, $v_2$, $v_3$,..., ) durch Codieren der codierten Eingabedatenbits ($b_0$, $b_1$, $b_2$,...,) in der Weise, dass

(a) jedes Bit des Wertes x in den codierten Eingabedaten ($b_0$, $b_1$, $b_2$,..., ) als ein Überschreibdatenbit des Wertes x codiert wird,
(b) jede begrenzte Folge von L $\leq$ 2d Bits des Wertes $\overline{x}$ in den codierten Eingabedaten ($b_0$, $b_1$, $b_2$,...,) als eine Folge von L Überschreibdatenbits des Wertes $\overline{x}$ codiert wird, und
(c) jede begrenzte Folge von L > 2d Bits des Wertes $\overline{x}$ in den codierten Eingabedaten ($b_0$, $b_1$, $b_2$,..., ) als eine Folge von L Überschreibdatenbits, die aus n Bits des Wertes x und (L - n) Bits des Wertes $\overline{x}$ bestehen, wobei n = CEIL[(L - 2d)/d], codiert wird und die n Bits in der Folge so positioniert sind, dass

(c1) ein Bit des Wertes x innerhalb von d Bits am Ende der Folge vorhanden ist,
(c2) ein Bit des Wertes x innerhalb von 2d + 1 Bits am Anfang der Folge vorhanden ist und
(c3) für n > 1 jedes der n Bits innerhalb von d Bits liegt, die von den n Bits verschieden sind.

11. Codiervorrichtung zum Codieren von Daten zur Speicherung in einer auf einer Sonde beruhenden Datenspeichervorrichtung (1), wobei Daten durch das Vorhandensein oder das Fehlen von Vertiefungen (Pits), die in einer Speicheroberfläche (4) durch eine Sonde der Vorrichtung ausgebildet werden, dargestellt werden, wobei die Vorrichtung Folgendes umfasst:

eine Codiereinrichtung (6) zum Codieren von Eingabedaten, die in der Einheit (1) gespeichert werden sollen, in der Weise, dass aufeinander folgende Bits eines Wertes x in den codierten Eingabedaten ($b_0$, $b_1$, $b_2$,..., ) durch wenigstens d Bits des Wertes $\overline{x}$ getrennt sind, wobei d eine vorgegebene Zahl $\geq 2$ ist;
einen Überschreibmustergenerator (7) zum Erzeugen von Überschreibdatenbits ($v_1$, $v_2$, $v_3$, ..., ) durch Codieren der codierten Eingabedatenbits ($b_0$, $b_1$, $b_2$,..., ) in der Weise, dass

(a) jedes Bit des Wertes x in den codierten Eingabedaten ($b_0$, $b_1$, $b_2$,..., ) als ein Überschreibdatenbit des Wertes $\overline{x}$ codiert wird,
(b) jede begrenzte Folge von L $\leq$ 2d Bits des Wertes $\overline{x}$ in den codierten Eingabedaten ($b_0$, $b_1$, $b_2$,..., ) als eine Folge von L Überschreibdatenbits des Wertes x codiert wird, und
(c) jede begrenzte Folge von L > 2d Bits des Wertes $\overline{x}$ in den codierten Eingabedaten ($b_0$, $b_1$, $b_2$,..., ) als

eine Folge von L Überschreibdatenbits, die aus n Bits des Wertes x und (L - n) Bits des Wertes x bestehen, wobei n = CEIL[(L - 2d)/d], codiert wird und die n Bits in der Folge so positioniert sind, dass

(c1) ein Bit des Wertes $\overline{x}$ innerhalb von d Bits am Ende der Folge vorhanden ist,

(c2) ein Bit des Wertes $\overline{x}$ innerhalb von 2d + 1 Bits am Anfang der Folge vorhanden ist und

(c3) für n > 1 jedes der n Bits innerhalb von d Bits liegt, die von den n Bits verschieden sind.

**12.** Vorrichtung (5) zum Codieren und Decodieren von Daten in einer auf einer Sonde beruhenden Datenspeichervorrichtung (1), wobei Daten durch das Vorhandensein oder das Fehlen von Vertiefungen (Pits), die in einer Speicheroberfläche (4) durch eine Sonde der Vorrichtung ausgebildet werden, dargestellt werden, wobei die Vorrichtung (5) Folgendes umfasst:

Codiervorrichtung nach Anspruch 10 oder Anspruch 11; und

eine Decodiereinrichtung (8) zum Decodieren von Daten, die von der Speicheroberfläche (4) gelesen werden, wobei die Decodiereinrichtung (8) beschaffen ist, um die Umkehrung des Codes, der durch die Codiereinrichtung (6) realisiert wird, zu realisieren.

**13.** Auf einer Sonde beruhende Datenspeichervorrichtung (1), die Folgendes umfasst:

eine Speicheroberfläche (4);

einen Sondenmechanismus (2) zum Speichern von Daten auf der Speicheroberfläche (4), indem darin Vertiefungen in der Weise ausgebildet werden, dass die Daten durch das Vorhandensein oder das Fehlen von Vertiefungen an Bitstellen auf der Oberfläche (4) dargestellt werden;

eine Codiereinrichtung (6) zum Codieren von Eingabedaten, die in der Einheit gespeichert werden sollen, in der Weise, dass aufeinander folgende Bits eines Wertes x in den codierten Eingabedaten ($b_0$, $b_1$, $b_2$,..., ) durch wenigstens d Bits des Wertes x getrennt sind, wobei d eine vorgegebene Zahl $\leq$ 2 ist;

einen Überschreibmustergenerator (7) zum Erzeugen von Überschreibdatenbits ($v_1$, $v_2$, $v_3$,..., ) durch Codieren der codierten Eingabedatenbits ($b_0$, $b_1$, $b_2$,..., ) in der Weise, dass

(a) jedes Bit des Wertes x in den codierten Eingabedaten ($b_0$, $b_1$, $b_2$,..., ) als ein Überschreibdatenbit des Wertes p codiert wird,

(b) jede begrenzte Folge von L $\leq$ 2d Bits des Wertes $\overline{x}$ in den codierten Eingabedaten ($b_0$, $b_1$, $b_2$,..., ) als eine Folge von L Überschreibdatenbits des Wertes $\overline{p}$ codiert wird, und

(c) jede begrenzte Folge von L > 2d Bits des Wertes $\overline{x}$ in den codierten Eingabedaten ($b_0$, $b_1$, $b_2$,..., ) als eine Folge von L Überschreibdatenbits, die aus n Bits des Wertes p und (L - n) Bits des Wertes $\overline{p}$ bestehen, wobei n = CEIL[(L - 2d)/d], codiert wird und die n Bits in der Folge so positioniert sind, dass

(c1) ein Bit des Wertes p innerhalb von d Bits am Ende der Folge vorhanden ist,

(c2) ein Bit des Wertes p innerhalb von 2d + 1 Bits am Anfang der Folge vorhanden ist und

(c3) für n > 1 jedes der n Bits innerhalb von d Bits liegt, die von den n Bits verschieden sind;

wobei der Sondenmechanismus (2) so beschaffen ist, dass er Daten auf der Speicheroberfläche (4) mit den Überschreibdatenbits ($v_1$, $v_2$, $v_3$, ..., ) bei einem Bitabstand überschreiben kann, so dass das Schreiben eines Überschreibdatenbits des Wertes p ein vorhandenes Bit des Wertes p innerhalb von d Bits dieses Überschreibdatenbits löschen kann.

**14.** Vorrichtung nach Anspruch 13, wobei der Überschreibmustergenerator (7) so beschaffen ist, dass er eine Folge von L Bits des Wertes $\overline{x}$ am Beginn der codierten Eingabedaten ($b_0$, $b_1$, $b_2$,..., ) für eine Überschreiboperation codieren kann, indem dann,

wenn L $\leq$ d, die Folge als eine Folge von L Überschreibdatenbits des Wertes $\overline{p}$ codiert wird,

wenn L > d, die Folge als eine Folge von L Überschreibdatenbits, die aus m Bits des Wertes p und (L - m) Bits des Wertes $\overline{p}$ bestehen, codiert wird, wobei m = CEIL[(L - d)/d] und die m Bits in der Folge in der Weise positioniert sind, dass

(1) ein Bit des Wertes p innerhalb von d Bits am Ende der Folge vorhanden ist,

(2) ein Bit des Wertes p innerhalb von d + 1 Bits am Anfang der Folge vorhanden ist und

(3) für m > 1 jedes der m Bits innerhalb von d Bits, die von den m Bits verschieden sind, liegt.

**15.** Vorrichtung nach Anspruch 13 oder Anspruch 14, wobei der Überschreibmustergenerator (7) beschaffen ist, um eine Folge von L Bits des Wertes $\overline{x}$ am Ende der codierten Eingabedaten ($b_0$, $b_1$, $b_2$,..., ) für eine Überschreiboperation zu codieren, indem dann,
wenn L ≤ d, die Folge als eine Folge von L Überschreibdatenbits des Wertes $\overline{p}$ codiert wird,
wenn d < L ≤ 2d, die Folge als eine Folge von (L + 1) Überschreibdatenbits codiert wird, die aus L Bits des Wertes $\overline{p}$ bestehen, die durch ein Bits des Wertes p abgeschlossen werden; und
wenn L > 2d, die Folge als eine Folge von (L + 1) Überschreibdatenbits codiert wird, die aus einer Folge von L Überschreibdatenbits gemäß der Bedingung (c) von Anspruch 13 bestehen, die durch ein Bit des Wertes p abgeschlossen werden.

**16.** Vorrichtung nach einem der Ansprüche 13 bis 15 mit einer Decodiereinrichtung (8) zum Decodieren von Daten, die von der Speicheroberfläche (4) gelesen werden, wobei die Decodiereinrichtung (8) so beschaffen ist, dass sie die Eingabedaten wiederherstellen kann, indem dann,
wenn der Wert x gleich dem Wert p ist, die Umkehrung der Codierung, die auf die Eingabedaten angewendet wird, um die codierten Eingabedaten ($b_0$, $b_1$, $b_2$,..., ) zu erzeugen, ausgeführt wird; und
wenn der Wert $\overline{x}$ gleich dem Wert p ist, Verwenden des Komplements der Daten, die von der Speicheroberfläche (4) gelesen werden, und anschließend Ausführen der Umkehrung der Codierung, die auf die Eingabedaten angewendet wird, um die codierten Eingabedaten ($b_0$, $b_1$, $b_2$,..., ) zu erzeugen.

**17.** Vorrichtung nach einem der Ansprüche 13 bis 16, wobei p = 1.

**18.** Vorrichtung nach einem der Ansprüche 13 bis 17, wobei der Sondenmechanismus (2) eine Vielzahl von einzeln adressierbaren Sonden zum Schreiben von Daten auf die Speicheroberfläche (4) umfasst.

**19.** Vorrichtung nach einem der Ansprüche 10 bis 18, wobei x = 1.

**20.** Vorrichtung nach einem der Ansprüche 10 bis 19, wobei d = 2.

**21.** Vorrichtung nach einem der Ansprüche 10 bis 20, wobei die Codiereinrichtung (6) so beschaffen ist, dass sie die Eingabedaten in der Weise codieren kann, dass aufeinander folgende Bits eines Wertes x in den codierten Eingabedaten ($b_0$, $b_1$, $b_2$,..., ) durch wenigstens d und höchstens k Bits des Wertes $\overline{x}$ getrennt sind, wobei k eine vorgegebene Zahl > d ist.

**22.** Vorrichtung nach Anspruch 21, wobei d = 2 und k = 10.

**Revendications**

**1.** Procédé d'écrasement de données dans un dispositif de stockage de données à base de sonde (1), dans lequel des données sont représentées par la présence et l'absence de trous formés dans une surface de stockage (4) par une sonde du dispositif, le procédé comprenant :

le codage de données d'entrée, de manière que des bits successifs d'une valeur x dans les données d'entrée codées ($b_0$, $b_1$, $b_2$, ... , ) soient séparés par au moins d bits de valeur $\overline{x}$, dans lequel d est un nombre prédéterminé ≥ 2 ;
la génération de bits de données d'écrasement ($v_0$, $v_1$, $V_2$, ... , ), par codage des bits de données d'entrée codées ($b_1$, $b_1$, $b_2$, ... , ), de manière que, si un trou représente un bit de valeur p dans le dispositif de stockage de donnés (1), alors :

(a) tout bit de valeur x, dans les données d'entrée codées ($b_0$, $b_1$, $b_2$, ... , ), est codé en tant que bit de données d'écrasement de valeur p,
(b) tout enchaînement borné de L ≤ 2d bits de valeur $\overline{x}$ dans les données d'entrée codées ($b_0$, $b_1$, $b_2$, ..., ) est codé en tant qu'enchaînement de L bits de données d'écrasement de valeur $\overline{p}$, et
(c) tout enchaînement borné de L > 2d bits de valeur $\overline{x}$ dans les données d'entrée codées ($b_0$, $b_1$, $b_2$, ... , ) est codé en tant qu'enchaînement de L bits de données d'écrasement constitués de n bits de valeur p et de (L-n) bits de valeur p, dans lequel n = CEIL[(L-2d)/d] et les n bits sont positionnés dans l'enchaînement de manière que :

(c1) il y ait un bit de valeur p dans d bits de la fin de l'enchaînement,

(c2) il y ait un bit de valeur p dans 2d+1 bits du commencement de l'enchaînement, et

(c3) pour n>1, chacun des n bits est dans les limites de d bits d'un autre des n bits ; et

l'écrasement de données sur la surface de stockage (4) avec les bits de données d'écrasement ($v_0$, $v_1$, $v_2$, ... , ), à un espacement entre bits tel que l'écriture d'un bit de données d'écrasement de valeur p peut effacer un bit existant de valeur p dans les limites de d bits de ce bit de données d'écrasement.

**2.** Procédé selon la revendication 1, comprenant, pour un enchaînement de L bits de valeur $\overline{x}$ au début des données d'entrée codées ($b_0$, $b_1$, $b_2$,...,) pour une opération d'écrasement :

si L ≤ d, codage de l'enchaînement en tant qu'enchaînement de L bits de données d'écrasement de valeur $\overline{p}$, et

si L > d, codage de l'enchaînement en tant qu'enchaînement de L bits de données d'écrasement constitués de m bits de valeur p et de (L-m) bits de valeur $\overline{p}$, dans lequel m = CEIL[(L-d)/d] et les m bits sont positionnés dans l'enchaînement de manière que :

(1) il y ait un bit de valeur p dans les limites de d bits de la fin de l'enchaînement,

(2) il y ait un bit de valeur p dans les limites de d+1 bits du commencement de l'enchaînement, et

(3) pour m > 1, chacun des m bits est dans les limites de d bits d'un autre des m bits.

**3.** Procédé selon la revendication 1 ou la revendication 2, comprenant, pour un enchaînement de L bits de valeur $\overline{x}$ à la fin des données d'entrée codées ($b_0$, $b_1$, $b_2$,...,) pour une opération d'écrasement :

si L ≤ d, codage de l'enchaînement en tant qu'enchaînement de L bits de données d'écrasement de valeur $\overline{p}$,

si d < L ≤ 2d, codage de l'enchaînement en tant qu'enchaînement de (L+1) bits de données d'écrasement constitués de L bits de valeur $\overline{p}$, terminé par un bit de valeur p ; et

si L > 2d, codage de l'enchaînement en tant qu'enchaînement de (L+1) bits de données d'écrasement constitués d'un enchaînement de L bits de données d'écrasement selon la condition (c) de la revendication 1, terminé par un bit de valeur p.

**4.** Procédé selon l'une quelconque des revendications précédentes, dans lequel p=1.

**5.** Procédé selon l'une quelconque des revendications précédentes, dans lequel x=1.

**6.** Procédé selon l'une quelconque des revendications précédentes, dans lequel d=2.

**7.** Procédé selon l'une quelconque des revendications précédentes, dans lequel les données d'entrée sont codées de manière que des bits successifs d'une valeur x dans les données d'entrée codées ($b_0$, $b_1$, $b_2$, ... , ) soient séparés par au moins d, et au plus k bits de valeur $\overline{x}$, dans lequel k est un nombre prédéterminé > d.

**8.** Procédé selon la revendication 7, dans lequel d = 2 et k =10.

**9.** Procédé de stockage et de récupération de données dans un dispositif de stockage de données à base de sonde (1), dans lequel des données sont représentées par la présence et l'absence de trous formés dans une surface de stockage (4) par une sonde du dispositif, le procédé comprenant le stockage de données sur la surface de stockage (4), par un procédé tel que revendiqué selon l'une quelconque des revendications précédentes, et le décodage de données lues de la surface de stockage (4), par le fait que :

- si ladite valeur x est égale à ladite valeur p dans le dispositif de stockage (1), effectuer l'inverse du codage appliqué aux données d'entrée pour générer lesdites données d'entrée codées ($b_0$, $b_1$, $b_2$, ..., ) ; et

- si ladite valeur $\overline{x}$ est égale à ladite valeur p dans le dispositif de stockage, prendre le complément des données lues de la surface de stockage et ensuite effectuer l'inverse du codage appliqué aux données d'entrée pour générer lesdites données d'entrée codées ($b_0$, $b_1$, $b_2$, ..., ) ;

de manière à récupérer lesdites données d'entrée.

**10.** Appareil de codage pour coder des données pour stockage dans un dispositif de stockage de données à base de sonde (1), dans lequel des données sont représentées par la présence et l'absence de trous formés dans une surface de stockage (4) par une sonde du dispositif, l'appareil comprenant :

un codeur (6), pour coder des données d'entrée devant être stockées dans le dispositif, de manière que des bits successifs d'une valeur x dans les données d'entrée codées ($b_0$, $b_1$, $b_2$, ...,) soient séparés par au moins d bits de valeur $\bar{x}$, dans lequel d est un nombre prédéterminé $\geq 2$ ;
un générateur de modèle d'écrasement (7), pour générer des bits de données d'écrasement ($v_0$, $v_1$, $v_2$, ... , ), par codage des bits de données d'entrée codées ($b_0$, $b_1$, $b_2$, ...,), de manière que :

(a) tout bit de valeur x, dans les données d'entrée codées ($b_0$, $b_1$, $b_2$, ... , ), soit codé en tant que bit de données d'écrasement de valeur x,
(b) tout enchaînement borné de L $\leq$ 2d bits de valeur $\bar{x}$ dans les données d'entrée codées ($b_0$, $b_1$, $b_2$, ... , ) soit codé en tant qu'enchaînement de L bits de données d'écrasement de valeur $\bar{x}$, et
(c) tout enchaînement borné de L > 2d bits de valeur $\bar{x}$ dans les données d'entrée codées ($b_0$, $b_1$, $b_2$, ...,) soit codé en tant qu'enchaînement de L bits de données d'écrasement constitués de n bits de valeur x et de (L-n) bits de valeur $\bar{x}$, dans lequel n = CEIL[(L-2d)/d] et les n bits sont positionnés dans l'enchaînement de manière que :

(c1) il y ait un bit de valeur x dans d bits de la fin de l'enchaînement,
(c2) il y ait un bit de valeur x dans 2d+1 bits du commencement de l'enchaînement, et
(c3) pour n>1, chacun des n bits est dans les limites de d bits d'un autre des n bits.

**11.** Appareil de codage pour coder des données pour stockage dans un dispositif de stockage de données à base de sonde (1), dans lequel des données sont représentées par la présence et l'absence de trous formés dans une surface de stockage (4) par une sonde du dispositif, l'appareil comprenant :

un codeur (6), pour coder des données d'entrée devant être stockées dans le dispositif (1), de manière que des bits successifs d'une valeur x dans les données d'entrée codées ($b_0$, $b_1$, $b_2$, ... , ) soient séparés par au moins d bits de valeur $\bar{x}$, dans lequel d est un nombre prédéterminé $\geq 2$ ;
un générateur de modèle d'écrasement (7), pour générer des bits de données d'écrasement ($v_0$, $v_1$, $v_2$, ... , ), par codage des bits de données d'entrée codées ($b0$, $b_1$, $b_2$, ... , ), de manière que :

(a) tout bit de valeur x, dans les données d'entrée codées ($b_0$, $b_1$, $b_2$, ..., ), soit codé en tant que bit de données d'écrasement de valeur $\bar{x}$,
(b) tout enchaînement borné de L $\leq$ 2d bits de valeur $\bar{x}$ dans les données d'entrée codées ($b_0$, $b_1$, $b_2$, ... , ) soit codé en tant qu'enchaînement de L bits de données d'écrasement de valeur x, et
(c) tout enchaînement borné de L > 2d bits de valeur $\bar{x}$ dans les données d'entrée codées ($b_0$, $b_1$, $b_2$, ...,) soit codé en tant qu'enchaînement de L bits de données d'écrasement constitués de n bits de valeur $\bar{x}$ et de (L-n) bits de valeur x, dans lequel n = CEIL[(L-2d)/d] et les n bits sont positionnés dans l'enchaînement de manière que :

(c1) il y ait un bit de valeur $\bar{x}$ dans d bits de la fin de l'enchaînement,
(c2) il y ait un bit de valeur $\bar{x}$ dans 2d+1 bits du commencement de l'enchaînement, et
(c3) pour n>1, chacun des n bits est dans les limites de d bits d'un autre des n bits.

**12.** Appareil (5) de codage et de décodage de données dans un dispositif de stockage de données à base de sonde (1), dans lequel dans lequel des données sont représentées par la présence et l'absence de trous formés dans une surface de stockage (4) par une sonde du dispositif, l'appareil comprenant :

un appareil de codage, tel que revendiqué selon la revendication 10 ou la revendication 11 ; et
un décodeur (8), pour décoder des données lues de la surface de stockage (4), le décodeur (8) étant agencé pour mettre en oeuvre l'inverse du code mis en oeuvre par ledit codeur (6).

**13.** Appareil de stockage de données à base de sonde (1), comprenant :

une surface de stockage (4) ;
un mécanisme à sonde (2), pour stocker des données sur la surface de stockage (4), par formation dans celle-ci de trous, de manière que des données soient représentées par la présence et l'absence de trous, en des emplacements de bit sur la surface (4) ;
un codeur (6), pour coder des données d'entrée devant être stockées dans le dispositif, de manière que des bits successifs d'une valeur x dans les données d'entrée codées ($b_0$, $b_1$, $b_2$, ... , ) soient séparés par au moins d bits de valeur $\overline{x}$, dans lequel d est un nombre prédéterminé $\geq 2$ ;
un générateur de modèle d'écrasement (7), pour générer des bits de données d'écrasement ($v_0$, $v_1$, $v_2$, ... , ), par codage des bits de données d'entrée codées ($b_0$, $b_1$, $b_2$, ...,), de manière que, si un trou représente un bit de valeur p, alors :

(a) tout bit de valeur x, dans les données d'entrée codées ($b_0$, $b_1$, $b_2$, ...,), est codé en tant que bit de données d'écrasement de valeur p,
(b) tout enchaînement borné de L $\leq$ 2d bits de valeur $\overline{x}$ dans les données d'entrée codées ($b_0$, $b_1$, $b_2$, ... , ) est codé en tant qu'enchaînement de L bits de données d'écrasement de valeur $\overline{p}$, et
(c) tout enchaînement borné de L > 2d bits de valeur $\overline{x}$ dans les données d'entrée codées ($b_0$, $b_1$, $b_2$, ... , ) est codé en tant qu'enchaînement de L bits de données d'écrasement constitués de n bits de valeur p et de (L-n) bits de valeur $\overline{p}$, dans lequel n = CEIL[(L-2d)/d] et les n bits sont positionnés dans l'enchaînement de manière que :

(c1) il y ait un bit de valeur p dans d bits de la fin de l'enchaînement,
(c2) il y ait un bit de valeur p dans 2d+1 bits du commencement de l'enchaînement, et
(c3) pour n>1, chacun des n bits est dans les limites de d bits d'un autre des n bits ; et

dans lequel le mécanisme à sonde (2) est agencé, en utilisation, pour écraser des données sur la surface de stockage (4) avec les bits de données d'écrasement ($v_0$, $v_1$, $v_2$, ... , ), selon un espacement entre bits tel que l'écriture d'un bit de données d'écrasement de valeur p puisse effacer un bit existant de valeur p, dans les limites de d bits de ce bit de données d'écrasement.

**14.** Appareil selon la revendication 13, dans lequel le générateur de modèle d'écrasement (7) est agencé pour coder un enchaînement de L bits de valeur $\overline{x}$, au début des données d'entrée codées ($b_0$, $b_1$, $b_2$, ...,) pour une opération d'écrasement, par le fait que :

si L $\leq$ d, codage de l'enchaînement en tant qu'enchaînement de L bits de données d'écrasement de valeur $\overline{p}$, et
si L > d, codage de l'enchaînement en tant qu'enchaînement de L bits de données d'écrasement constitués de m bits de valeur p et de (L-m) bits de valeur p, dans lequel m = CEIL[(L-d)/d] et les m bits sont positionnés dans l'enchaînement de manière que :

(1) il y ait un bit de valeur p dans les limites de d bits de la fin de l'enchaînement,
(2) il y ait un bit de valeur p dans les limites de d+1 bits du commencement de l'enchaînement, et
(3) pour m > 1, chacun des m bits est dans les limites de d bits d'un autre des m bits.

**15.** Appareil selon la revendication 13 ou la revendication 14, dans lequel le générateur de modèle d'écrasement (7) est agencé pour coder un enchaînement de L bits de valeur $\overline{x}$, à la fin des données d'entrée codées ($b_0$, $b_1$, $b_2$, ...,) pour une opération d'écrasement, par le fait que :

si L $\leq$ d, codage de l'enchaînement en tant qu'enchaînement de L bits de données d'écrasement de valeur $\overline{p}$,
si d < L $\leq$ 2d, codage de l'enchaînement en tant qu'enchaînement de (L+1) bits de données d'écrasement constitués de L bits de valeur $\overline{p}$, terminé par un bit de valeur p ; et
si L > 2d, codage de l'enchaînement en tant qu'enchaînement de (L+1) bits de données d'écrasement constitués d'un enchaînement de L bits de données d'écrasement selon la condition (c) de la revendication 13, terminé par un bit de valeur p.

**16.** Appareil selon l'une quelconque des revendications 13 à 15, comprenant un décodeur (8), pour décoder des données lues de la surface de stockage (4), le décodeur (8) étant agencé pour récupérer les données d'entrées par le fait que :

- si ladite valeur x est égale à ladite valeur p, effectuer l'inverse du codage appliqué aux données d'entrée pour générer lesdites données d'entrée codées ($b_0$, $b_1$, $b_2$, ...,) ; et
- si ladite valeur $\overline{x}$ est égale à ladite valeur p, prendre le complément des données lues de la surface de stockage (4) et ensuite effectuer l'inverse du codage appliqué aux données d'entrée pour générer lesdites données d'entrée codées ($b_0$, $b_1$, $b_2$, ... , ).

**17.** Appareil selon l'une quelconque des revendications 13 à 16, dans lequel p = 1.

18. Appareil selon l'une quelconque des revendications 13 à 17, dans lequel le mécanisme à sonde (2) comprend une pluralité de sondes adressables individuellement, pour écrire des données sur la surface de stockage (4).

19. Appareil selon l'une quelconque des revendications 10 à 18, dans lequel x = 1.

20. Appareil selon l'une quelconque des revendications 10 à 19, dans lequel d = 2.

21. Appareil selon l'une quelconque des revendications 10 à 20, dans lequel le codeur (6) est agencé pour coder les données d'entrée, de manière que des bits successifs d'une valeur x dans les données d'entrée codées ($b_0$, $b_1$, $b_2$, ...,) soient séparés par au moins d et au plus k bits de valeur $\overline{x}$, dans lequel k est un nombre prédéterminé > d.

22. Appareil selon la revendication 21, dans lequel d = 2 et k = 10.

Figure 1

Figure 2

Figure 3

| | (2,10) coded pattern $b_i,...$ | overwrite pattern $v_i,...$ |
|---|---|---|
| 1 | 0 0 : 1 | 0 0 : 1 |
| 2 | 0 0 0 : 1 | 0 0 0 : 1 |
| 3 | 0 0 0 0 : 1 | 0 0 0 0 : 1 |
| 4 | 0 0 0 0 0 : 1 | 0 0 0 1 0 : 1<br>0 0 0 0 1 : 1 |
| 5 | 0 0 0 0 0 0 : 1 | 0 0 0 0 1 0 : 1 |
| 6 | 0 0 0 0 0 0 0 : 1 | 0 0 0 1 0 1 0 : 1<br>0 0 0 0 1 0 1 : 1<br>0 0 0 0 1 1 0 : 1 |
| 7 | 0 0 0 0 0 0 0 0 : 1 | 0 0 0 0 1 0 1 0 : 1 |
| 8 | 0 0 0 0 0 0 0 0 0 : 1 | 0 0 0 1 0 1 0 1 0 : 1<br>0 0 0 0 1 0 1 0 1 : 1<br>0 0 0 0 1 0 1 1 0 : 1<br>0 0 0 0 1 1 0 1 0 : 1 |
| 9 | 0 0 0 0 0 0 0 0 0 0 : 1 | 0 0 0 0 1 0 1 0 1 0 : 1 |

Figure 4

| | start pattern $b_i,...$ | overwrite pattern $v_i,...$ |
|---|---|---|
| 1 | 0 : 1 | 0 : 1 |
| 2 | 0 0 : 1 | 0 0 : 1 |
| 3 | 0 0 0 : 1 | 0 1 0 : 1<br>0 0 1 : 1 |
| 4 | 0 0 0 0 : 1 | 0 0 1 0 : 1 |
| 5 | 0 0 0 0 0 : 1 | 0 1 0 1 0 : 1<br>0 0 1 0 1 : 1<br>0 0 1 1 0 : 1 |
| 6 | 0 0 0 0 0 0 : 1 | 0 0 1 0 1 0 : 1 |
| 7 | 0 0 0 0 0 0 0 : 1 | 0 1 0 1 0 1 0 : 1<br>0 0 1 0 1 0 1 : 1<br>0 0 1 0 1 1 0 : 1<br>0 0 1 1 0 1 0 : 1 |
| 8 | 0 0 0 0 0 0 0 0 : 1 | 0 0 1 0 1 0 1 0 : 1 |
| 9 | 0 0 0 0 0 0 0 0 0 : 1 | 0 1 0 1 0 1 0 1 0 : 1<br>0 0 1 0 1 0 1 0 1 : 1<br>0 0 1 0 1 0 1 1 0 : 1<br>0 0 1 0 1 1 0 1 0 : 1<br>0 0 1 1 0 1 0 1 0 : 1 |
| 10 | 0 0 0 0 0 0 0 0 0 0 : 1 | 0 0 1 0 1 0 1 0 1 0 : 1 |

| | end pattern $b_i,...$ | overwrite pattern $v_i,...$ |
|---|---|---|
| 1 | 0 | 0 |
| 2 | 0 0 | 0 0 |
| 3 | 0 0 0 | 0 0 0 1 |
| 4 | 0 0 0 0 | 0 0 0 0 1 |
| 5 | 0 0 0 0 0 | 0 0 0 1 0 1<br>0 0 0 0 1 1 |
| 6 | 0 0 0 0 0 0 | 0 0 0 0 1 0 1 |
| 7 | 0 0 0 0 0 0 0 | 0 0 0 1 0 1 0 1<br>0 0 0 0 1 0 1 1<br>0 0 0 0 1 1 0 1 |
| 8 | 0 0 0 0 0 0 0 0 | 0 0 0 0 1 0 1 0 1 |
| 9 | 0 0 0 0 0 0 0 0 0 | 0 0 0 1 0 1 0 1 0 1<br>0 0 0 0 1 0 1 0 1 1<br>0 0 0 0 1 0 1 1 0 1<br>0 0 0 0 1 1 0 1 0 1 |
| 10 | 0 0 0 0 0 0 0 0 0 0 | 0 0 0 0 1 0 1 0 1 0 1 |

## Figure 5

| coded $b_i$ pattern | Method 1 overwrite pattern | Method 2 overwrite pattern | New overwrite pattern |
|---|---|---|---|
| 001 | 011 | 001 | 001 |
| 0001 | 0111 | 0011 | 0001 |
| 00001 | 01111 | 00111 | 00001 |
| 000001 | 011111 | 001111 | 000101 |
| 0000001 | 0111111 | 0011111 | 0000101 |
| 00000001 | 01111111 | 00111111 | 00010101 |
| 000000001 | 011111111 | 001111111 | 000010101 |
| 0000000001 | 0111111111 | 0011111111 | 0001010101 |
| 00000000001 | 01111111111 | 00111111111 | 00001010101 |

## Figure 7

| | |
|---|---|
| old data | 0 1 0 0 1 0 0 1 0 0 0 1 0 0 1 0 0 1 |
| new b$_i$ sequence | 1 0 0 1 0 0 0 0 0 1 0 0 0 1 0 0 0 |
| overwrite (v$_i$) sequence | 1 0 0 1 0 0 0 0 1 0 1 0 0 0 1 0 0 0 1 |

write: v$_0$  1 0 0 0 1 0 0 1 0 0 0 1 0 0 1 0 0 1
v$_1$  1 0 0 0 1 0 0 1 0 0 0 1 0 0 1 0 0 1
v$_2$  1 0 0 0 1 0 0 1 0 0 0 1 0 0 1 0 0 1
v$_3$  1 0 0 1 0 0 0 1 0 0 0 1 0 0 1 0 0 1
v$_4$  1 0 0 1 0 0 0 1 0 0 0 1 0 0 1 0 0 1
v$_5$  1 0 0 1 0 0 0 1 0 0 0 1 0 0 1 0 0 1
v$_6$  1 0 0 1 0 0 0 1 0 0 0 1 0 0 1 0 0 1
v$_7$  1 0 0 1 0 0 0 1 0 0 0 1 0 0 1 0 0 1
v$_8$  1 0 0 1 0 0 0 0 1 0 0 1 0 0 1 0 0 1
v$_9$  1 0 0 1 0 0 0 0 1 0 0 1 0 0 1 0 0 1
v$_{10}$  1 0 0 1 0 0 0 0 0 0 1 0 0 0 1 0 0 1
v$_{11}$  1 0 0 1 0 0 0 0 0 0 1 0 0 0 1 0 0 1
v$_{12}$  1 0 0 1 0 0 0 0 0 0 1 0 0 0 1 0 0 1
v$_{13}$  1 0 0 1 0 0 0 0 0 0 1 0 0 0 1 0 0 1
v$_{14}$  1 0 0 1 0 0 0 0 0 0 1 0 0 0 1 0 0 1
v$_{15}$  1 0 0 1 0 0 0 0 0 0 1 0 0 0 1 0 0 1
v$_{16}$  1 0 0 1 0 0 0 0 0 0 1 0 0 0 1 0 0 1
v$_{17}$  1 0 0 1 0 0 0 0 0 0 1 0 0 0 1 0 0 1
v$_{18}$  1 0 0 1 0 0 0 0 0 0 1 0 0 0 1 0 0 1

## Figure 6

| | $p_2$ | $p_3$ | $p_4$ | $p_5$ | $p_6$ | $p_7$ | $p_8$ | $p_9$ | $p_{10}$ |
|---|---|---|---|---|---|---|---|---|---|
| Code 1 | 0.291 | 0.210 | 0.154 | 0.111 | 0.081 | 0.060 | 0.046 | 0.029 | 0.018 |
| Code 2 | 0.314 | 0.252 | 0.164 | 0.106 | 0.069 | 0.044 | 0.028 | 0.018 | 0.005 |

Figure 8

| | Simple Write | Method 1 | Method 2 | New Method |
|---|---|---|---|---|
| Code 1 | $P_w$ | $4.098P_w$ | $3.098P_w$ | $1.545P_w$ |
| Code 2 | $P_w$ | $3.728P_w$ | $2.728P_w$ | $1.388P_w$ |

Figure 9

| | Method 1 | Method 2 | New Method |
|---|---|---|---|
| Code 1 | 1.0 | 0.756 | 0.377 |
| Code 2 | 1.0 | 0.732 | 0.372 |

Figure 10

**Figure 11**

| | d=3 coded pattern $b_i,...$ | overwrite pattern $v_i,...$ |
|---|---|---|
| 1 | 0 0 0 1 | 0 0 0 1 |
| 2 | 0 0 0 0 1 | 0 0 0 0 1 |
| 3 | 0 0 0 0 0 1 | 0 0 0 0 0 1 |
| 4 | 0 0 0 0 0 0 1 | 0 0 0 0 0 0 1 |
| 5 | 0 0 0 0 0 0 0 1 | 0 0 0 0 1 0 0 1<br>0 0 0 0 0 1 0 1<br>0 0 0 0 0 0 1 1 |
| 6 | 0 0 0 0 0 0 0 0 1 | 0 0 0 0 0 1 0 0 1<br>0 0 0 0 0 0 1 0 1 |
| 7 | 0 0 0 0 0 0 0 0 0 1 | 0 0 0 0 0 0 1 0 0 1 |
| 8 | 0 0 0 0 0 0 0 0 0 0 1 | 0 0 0 0 1 0 0 1 0 0 1<br>0 0 0 0 0 1 0 1 0 0 1<br>0 0 0 0 0 0 1 1 0 0 1<br>0 0 0 0 0 1 0 0 1 0 1<br>0 0 0 0 0 0 1 0 1 0 1<br>0 0 0 0 0 0 1 0 0 1 1 |

**Figure 12**

| | (2,10) coded pattern $b_i,...$, for x=0 | overwrite pattern $v_i,...$, for p=1 |
|---|---|---|
| 1 | 1 1 0 | 0 0 1 |
| 2 | 1 1 1 0 | 0 0 0 1 |
| 3 | 1 1 1 1 0 | 0 0 0 0 1 |
| 4 | 1 1 1 1 1 0 | 0 0 0 1 0 1<br>0 0 0 0 1 1 |
| 5 | 1 1 1 1 1 1 0 | 0 0 0 0 1 0 1 |
| 6 | 1 1 1 1 1 1 1 0 | 0 0 0 1 0 1 0 1<br>0 0 0 0 1 0 1 1<br>0 0 0 0 1 1 0 1 |
| 7 | 1 1 1 1 1 1 1 1 0 | 0 0 0 0 1 0 1 0 1 |
| 8 | 1 1 1 1 1 1 1 1 1 0 | 0 0 0 1 0 1 0 1 0 1<br>0 0 0 0 1 0 1 0 1 1<br>0 0 0 0 1 0 1 1 0 1<br>0 0 0 0 1 1 0 1 0 1 |
| 9 | 1 1 1 1 1 1 1 1 1 1 0 | 0 0 0 0 1 0 1 0 1 0 1 |

| | |
|---|---|
| old data | 0 1 0 0 1 0 0 1 0 0 0 1 0 0 1 0 0 1 |
| new $b_i$ sequence | 0 1 1 0 1 1 1 1 1 1 0 1 1 1 0 1 1 1 |
| overwrite ($v_i$) sequence | 1 0 0 1 0 0 0 0 1 0 1 0 0 0 1 0 0 0 1 |

| | |
|---|---|
| write: $v_0$ | 1 0 0 0 1 0 0 1 0 0 0 1 0 0 1 0 0 1 0 0 1 |
| $v_1$ | 1 0 0 0 1 0 0 1 0 0 0 1 0 0 1 0 0 1 0 0 1 |
| $v_2$ | 1 0 0 0 1 0 0 1 0 0 0 1 0 0 1 0 0 1 0 0 1 |
| $v_3$ | 1 0 0 1 0 0 0 1 0 0 0 1 0 0 1 0 0 1 0 0 1 |
| $v_4$ | 1 0 0 1 0 0 0 1 0 0 0 1 0 0 1 0 0 1 0 0 1 |
| $v_5$ | 1 0 0 1 0 0 0 1 0 0 0 1 0 0 1 0 0 1 0 0 1 |
| $v_6$ | 1 0 0 1 0 0 0 1 0 0 0 1 0 0 1 0 0 1 0 0 1 |
| $v_7$ | 1 0 0 1 0 0 0 1 0 0 0 1 0 0 1 0 0 1 0 0 1 |
| $v_8$ | 1 0 0 1 0 0 0 0 1 0 0 1 0 0 1 0 0 1 0 0 1 |
| $v_9$ | 1 0 0 1 0 0 0 0 1 0 0 1 0 0 1 0 0 1 0 0 1 |
| $v_{10}$ | 1 0 0 1 0 0 0 0 0 0 1 0 0 0 0 1 0 0 1 0 0 1 |
| $v_{11}$ | 1 0 0 1 0 0 0 0 0 0 1 0 0 0 0 1 0 0 1 |
| $v_{12}$ | 1 0 0 1 0 0 0 0 0 0 1 0 0 0 1 0 0 1 |
| $v_{13}$ | 1 0 0 1 0 0 0 0 0 0 1 0 0 0 1 0 0 1 |
| $v_{14}$ | 1 0 0 1 0 0 0 0 0 0 1 0 0 1 0 0 1 |
| $v_{15}$ | 1 0 0 1 0 0 0 0 0 0 1 0 0 1 0 0 1 |
| $v_{16}$ | 1 0 0 1 0 0 0 0 0 0 1 0 0 0 1 0 0 1 |
| $v_{17}$ | 1 0 0 1 0 0 0 0 0 0 1 0 0 0 1 0 0 1 |
| $v_{18}$ | 1 0 0 1 0 0 0 0 0 0 1 0 0 0 1 0 0 1 |

## Figure 13

28

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 02010648 A
- EP 0718831 A2
- EP 0991060 A2
- EP 1056077 A2

**Non-patent literature cited in the description**

- **Vettiger.** The 'Millipede'- More Than One Thousand Tips for Future AFM Data Storage. *ISM Journal of Research & Development,* May 2000, vol. 44 (3), 323-340